(19) Europäisches Patentamt / European Patent Office / Office européen des brevets

(11) **EP 2 739 702 B1**

(12) **EUROPÄISCHE PATENTSCHRIFT**

(45) Veröffentlichungstag und Bekanntmachung des Hinweises auf die Patenterteilung:
**30.03.2016 Patentblatt 2016/13**

(21) Anmeldenummer: **12753670.4**

(22) Anmeldetag: **02.08.2012**

(51) Int Cl.:
***H01L 51/56*** *(2006.01)* ***C09K 11/06*** *(2006.01)*
***H01L 51/50*** *(2006.01)* ***C01G 3/00*** *(2006.01)*
***C07F 9/58*** *(2006.01)* ***H01L 51/00*** *(2006.01)*

(86) Internationale Anmeldenummer:
**PCT/EP2012/065203**

(87) Internationale Veröffentlichungsnummer:
**WO 2013/017675 (07.02.2013 Gazette 2013/06)**

(54) **SINGULETT-HARVESTING MIT ZWEIKERNIGEN KUPFER(I)-KOMPLEXEN FÜR OPTO-ELEKTRONISCHE VORRICHTUNGEN**

SINGLET HARVESTING WITH TWO-CORE COPPER(I) COMPLEXES FOR OPTO-ELECTRONIC DEVICES

PRÉLÈVEMENT SINGULET DOTÉ DE COMPLEXES CUIVRE(I) BI-COEUR POUR DISPOSITIFS OPTO-ÉLECTRONIQUES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **02.08.2011 DE 102011080240**
**29.03.2012 EP 12162191**

(43) Veröffentlichungstag der Anmeldung:
**11.06.2014 Patentblatt 2014/24**

(73) Patentinhaber: **cynora GmbH**
**76646 Bruchsal (DE)**

(72) Erfinder:
- **YERSIN, Hartmut**
  **93161 Sinzing (DE)**
- **MONKOWIUS, Uwe**
  **4020 Linz (AT)**
- **HOFBECK, Thomas**
  **92342 Freystadt (DE)**

(74) Vertreter: **Hoppe, Georg Johannes**
**Darani Anwaltskanzlei**
**Beuckestrasse 20**
**14163 Berlin (DE)**

(56) Entgegenhaltungen:
**WO-A1-2005/054404 WO-A1-2011/063083**
**DE-A1-102009 030 475 US-A1- 2007 111 026**
**US-A1- 2008 064 893**

- **JOSEPH C. DEATON ET AL: "E-Type Delayed Fluorescence of a Phosphine-Supported Cu 2 ([mu]-NAr 2 ) 2 Diamond Core: Harvesting Singlet and Triplet Excitons in OLEDs ||", JOURNAL OF THE AMERICAN CHEMICAL SOCIETY, Bd. 132, Nr. 27, 17. Juni 2010 (2010-06-17), Seiten 9499-9508, XP055031756, ISSN: 0002-7863, DOI: 10.1021/ja1004575**
- **SETH B. HARKINS ET AL: "Probing the Electronic Structures of [Cu 2 ([mu]-XR 2 )] n + Diamond Cores as a Function of the Bridging X Atom (X = N or P) and Charge ( n = 0, 1, 2)", JOURNAL OF THE AMERICAN CHEMICAL SOCIETY, Bd. 130, Nr. 11, 26. Februar 2008 (2008-02-26), Seiten 3478-3485, XP055031757, ISSN: 0002-7863, DOI: 10.1021/ja076537v**
- **DANIEL M. ZINK ET AL: "Experimental and Theoretical Study of Novel Luminescent Di-, Tri-, and Tetranuclear Copper Triazole Complexes", ORGANOMETALLICS, Bd. 30, Nr. 12, 20. Mai 2011 (2011-05-20), Seiten 3275-3283, XP055031742, ISSN: 0276-7333, DOI: 10.1021/om1011648**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

- KEVIN R. KYLE ET AL: "Photophysical studies in solution of the tetranuclear copper(I) clusters Cu4I4L4 (L = pyridine or substituted pyridine)", JOURNAL OF THE AMERICAN CHEMICAL SOCIETY, Bd. 113, Nr. 8, 1. April 1991 (1991-04-01) , Seiten 2954-2965, XP055031750, ISSN: 0002-7863, DOI: 10.1021/ja00008a026

## Beschreibung

Die vorliegende Erfindung betrifft neuartige dimere Kupfer(I)-Komplexe und deren Verwendung, insbesondere als Emitter in opto-elektronischen Vorrichtungen wie organischen lichtemittierenden Dioden (OLEDs) und anderen.

## Hintergrund

Zur Zeit setzen sich im Bereich der Bildschirm- und Licht-Technik neue Verfahren durch. Es wird möglich sein, flache Displays oder Leuchtflächen mit einer Dicke von unter 0,5 mm zu fertigen. Diese sind durch viele faszinierende Eigenschaften ausgezeichnet. So werden z. B. Leuchtflächen als Tapeten mit sehr geringem Energieverbrauch realisierbar sein. Besonders interessant ist auch, dass Farbbildschirme mit bisher nicht erreichbarer Farb-Echtheit, Helligkeit und Blickwinkelunabhängigkeit, mit geringem Gewicht sowie sehr niedrigem Stromverbrauch herstellbar sein werden. Die Bildschirme werden sich als Mikro-Displays oder Großbildschirme mit mehreren Quadratmetern Fläche in starrer Form oder flexibel, aber auch als Transmissions- oder Reflexions-Displays gestalten lassen. Ferner wird es möglich sein, einfache und kostensparende Herstellungsverfahren wie Siebdruck oder Tintenstrahldruck einzusetzen. Dadurch wird im Vergleich zu herkömmlichen Flachbildschirmen eine sehr preiswerte Fertigung ermöglicht. Diese neue Technik basiert auf dem Prinzip der OLEDs, den "Organic Light Emitting Diodes". Darüber hinaus zeichnen sich durch die Verwendung spezieller metall-organischer Materialien (Moleküle) viele neue opto-elektronische Anwendungen, z. B. im Bereich organischer Solarzelle, organischer Feldeffekttransistoren, organischer Photodioden usw. ab.

So lässt sich besonders für den OLED-Bereich erkennen, dass derartige Anordnungen bereits jetzt wirtschaftlich bedeutend sind, da eine Massenfertigung von OLED-Handy-Displays bereits aufgenommen wurde. Derartige OLEDs bestehen vorwiegend aus organischen Schichten, die auch flexibel und kostengünstig zu fertigen sind. Hervorzuheben ist, dass sich OLED-Bauelemente großflächig als Beleuchtungskörper, aber auch klein als Pixels für Displays gestalten gestalten lassen.

Gegenüber herkömmlichen Technologien, wie etwa Flüssigkristall-Displays (LCDs), Plasma-Displays oder Kathodenstrahlenröhren (CRTs) weisen OLEDs zahlreiche Vorteile auf, wie eine geringe Betriebsspannung von einigen Volt, eine dünne Struktur von einigen hundert nm, hoch-effizient selbst-leuchtende Pixel, einen hohen Kontrast und eine gute Auflösung sowie die Möglichkeit, alle Farben darzustellen. Weiterhin wird in einem OLED Licht beim Anliegen elektrischer Spannung direkt erzeugt, anstelle es nur zu modulieren.

Einen Überblick über die Funktion von OLEDs findet sich beispielsweise bei H. Yersin, Top. Curr. Chem. 2004, 241, 1 und H. Yersin, "Highly Efficient OLEDs with Phosphorescent Materials"; Wiley-VCH, Weinheim, Germany, 2008.

Seit den ersten Berichten über OLEDs (siehe z. B. Tang et al., Appl. Phys. Lett. 1987, 51, 913) sind diese Vorrichtungen insbesondere im Hinblick auf die eingesetzten Emittermaterialien weiterentwickelt worden, wobei insbesondere in den letzten Jahren sogenannte Triplett- oder auch andere phosphoreszierende Emitter von Interesse sind.

OLEDs werden in der Regel in Schichtenstrukturen realisiert. Zum besseren Verständnis ist in Figur 1 ein prinzipieller Aufbau eines OLEDs gezeigt. Aufgrund der angelegten äußeren Spannung an einer transparenten Indium-Zinn-Oxid-Anode (ITO) und einer dünnen Metall-Kathode werden von der Anode positive Löcher und von der Kathode negative Elektronen injiziert. Diese verschieden geladenen Ladungsträger gelangen über Zwischenschichten, zu denen auch hier nicht gezeichnete Loch- bzw. Elektronen-Blockierschichten gehören können, in die Emissionsschicht. Dort treffen die entgegengesetzt geladenen Ladungsträger an oder in der Nähe von dotierten Emitter-Molekülen zusammen und rekombinieren. Die Emitter-Moleküle sind in der Regel in Matrix-Molekülen oder Polymermatrizen (in z. B. 2 bis 10 Gew.-%) eingelagert, wobei die Matrix-Materialien so gewählt sind, dass sie auch einen Loch- und Elektronentransport ermöglichen. Durch die Rekombination entstehen Exzitonen (= Anregungszustände), die ihre Überschussenergie auf die jeweilige elektrolumineszierende Verbindung übertragen. Diese elektrolumineszierende Verbindung kann daraufhin in einen bestimmten elektronischen Anregungszustand übergehen, der dann möglichst vollständig und unter weitgehender Vermeidung strahlungsloser Desaktivierungsprozesse durch Lichtemission in den zugehörigen Grundzustand umgewandelt wird.

Als elektronischer Anregungszustand, der auch durch Energieübertragung von einem geeigneten Vorläufer-Exziton gebildet werden kann, kommt, von wenigen Ausnahmen abgesehen, entweder ein Singulett- oder ein Triplett-Zustand, bestehend aus drei Unterzuständen, in Betracht. Da beide Zustände aufgrund der Spinstatistik in der Regel im Verhältnis 1:3 besetzt werden, ergibt sich, dass bei einer Emission aus dem Singulett-Zustand, die als Fluoreszenz bezeichnet wird, nur maximal 25 % der erzeugten Exzitonen wieder zur Emission führen. Dagegen können bei einer Triplett-Emission, die als Phosphoreszenz bezeichnet wird, sämtliche Exzitonen ausgenutzt, umgewandelt und als Licht emittiert werden (Triplett-Harvesting), so dass in diesem Fall die Innere Quantenausbeute den Wert von 100 % erreichen kann, sofern der mit angeregte und energetisch über dem Triplett-Zustand liegende Singulett-Zustand vollständig in den Triplett-Zustand relaxiert (Inter-System-Crossing, ISC) und strahlungslose Konkurrenzprozesse bedeutungslos bleiben. Somit sind Triplett-Emitter nach dem bisherigen Stand der Technik effizientere Elektro-Luminophore und besser geeignet, in einer organischen Leuchtdiode für eine hohe Lichtausbeute zu sorgen.

Bei den für das Triplett-Harvesting geeigneten Triplett-Emittern werden in der Regel Übergangsmetall-Komplexverbindungen eingesetzt, in denen das Metall aus der dritten Periode der Übergangsmetalle gewählt wird. Hierbei handelt es sich vorwiegend um sehr teure Edelmetalle wie Iridium, Platin oder auch Gold (siehe dazu auch H. Yersin, Top. Curr. Chem. 2004, 241, 1 und M. A. Baldo, D. F. O'Brien, M. E. Thompson, S. R. Forrest, Phys. Rev. B 1999, 60, 14422). Der wesentliche Grund dafür liegt in der hohen Spin-Bahn-Kopplung (SBK) der Edelmetall-Zentralionen (SBK-Konstante Ir(III): ≈ 4000 $cm^{-1}$; Pt(II): ≈ 4500 $cm^{-1}$; Au(I): ≈ 5100 $cm^{-1}$; Ref.: S. L. Murov, J. Carmicheal, G. L. Hug, Handbook of Photochemistry, 2nd Edition, Marcel Dekker, New York 1993, S. 338 ff). Durch diese quantenmechanische Eigenschaft wird der ohne SBK für optische Übergänge strikt verbotene Triplett-Singulett-Übergang erlaubt und die für die OLED-Anwendung erforderliche kurze Emissionslebensdauer von wenigen μs erreicht.

Es wäre von großem wirtschaftlichem Vorteil, wenn diese teuren Edelmetalle durch preiswerte Metalle ersetzt werden könnten. Darüber hinaus ist eine Vielzahl der bisher bekannten OLED-Emitter-Materialien aus ökologischer Sicht nicht unbedenklich, so dass die Verwendung von weniger toxischen Materialien wünschenswert wäre. Hierfür kämen z. B. Kupfer(I)-Komplexe in Betracht. Allerdings weisen diese eine wesentlich geringere SBK auf (SBK-Konstanten von Cu(I): ≈ 850 $cm^{-1}$, Ref.: S. L. Murov, J. Carmicheal, G. L. Hug, Handbook of Photochemistry, 2nd Edition, Marcel Dekker, New York 1993, S. 338 ff), als die oben genannten Zentralionen. Damit wären die sehr wichtigen Triplett-Singulett-Übergänge von Cu(I)-Komplexen relativ stark verboten, und Emissionslebensdauern wären für OLED-Anwendungen mit einigen 100 μs bis ms zu lang. Bei derart langen Emissionsabklingzeiten ergeben sich mit wachsenden Stromdichten und die dadurch resultierende Besetzung eines Großteils oder aller Emittermoleküle ausgeprägte Sättigungseffekte. In der Folge können weitere Ladungsträger-Ströme nicht mehr vollständig zur Besetzung der angeregten und emittierenden Zustände führen. Es resultieren dann nur unerwünschte ohmsche Verluste. Infolgedessen ergibt sich mit steigender Stromdichte ein deutlicher Effizienz-Abfall des OLED-Devices (sog. "Roll-Off" Verhalten). In ähnlich ungünstiger Weise wirken sich die Effekte der Triplett-Triplett-Annihilation und des Self-Quenchens aus (siehe dazu z. B. H. Yersin, "Highly Efficient OLEDs with Phosphorescent Materials", Wiley-VCH, Weinheim 2008 und S. R. Forrest et al., Phys. Rev. B 2008, 77, 235215). So zeigen sich insbesondere Nachteile bei der Verwendung derartiger Emitter für OLED-Beleuchtungen, bei denen eine hohe Leuchtdichte, z. B. von einigen 1000 $cd/m^2$ gefordert wird (Vergleiche: J. Kido et al. Jap. J. Appl. Phys. 2007, 46, L10). Darüber hinaus sind Moleküle in elektronisch angeregten Zuständen in der Regel chemisch reaktiver als Moleküle in Grundzuständen, so dass die Wahrscheinlichkeit unerwünschter chemischer Reaktionen mit der Länge der Emissionslebensdauer wächst. Durch derartige unerwünschte chemische Reaktionen wird dann die Device-Lebensdauer verringert.

Darüber hinaus erfolgen in der Regel in Cu(I)-Komplexen nach dem Anregungsprozess (durch Elektron-Loch-Rekombination oder durch optische Anregung) ausgeprägte Geometrie-Veränderungen, wodurch die Emissionsquantenausbeuten stark reduziert werden. Ferner werden durch diese Prozesse die Emissionsfarben in unerwünschter Weise rot-verschoben.

Aus der WO 2005/054404 A1 ist eine Vorrichtung bekannt, aufweisend ein lumineszierendes Material mit einer hohen Lumineszenzeffizienz und hoher Stabilität.

Es ist Ziel dieser Erfindung, neue Materialien bereitzustellen, die die oben genannten Nachteile nicht aufweisen.

Kurze Beschreibung der Erfindung

Überraschender Weise wird das Ziel der Erfindung durch Kupfer(I)-Komplexe (Cu(I)-Komplexe) erreicht, die zur Emission von Licht fähig sind und eine Struktur gemäß Formel A aufweisen

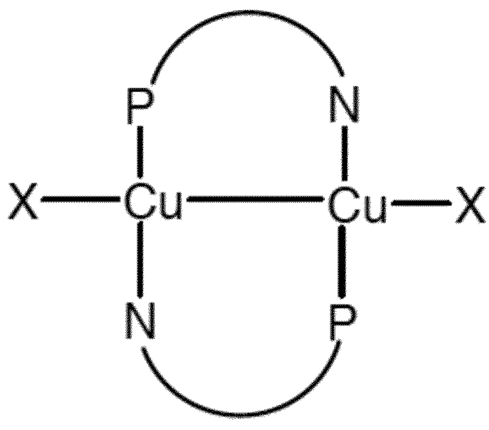

**Formel A**

In Formel A bedeutet

Cu: Cu(I);
X: Cl, Br, I, SCN, CN, und/oder Alkinyl (R*-≡) (R* ist definiert wie R);
P∩N: ein mit einem N-Heterocyclus substituierter Phosphanligand, insbesondere mit einer Struktur gemäß Formel B

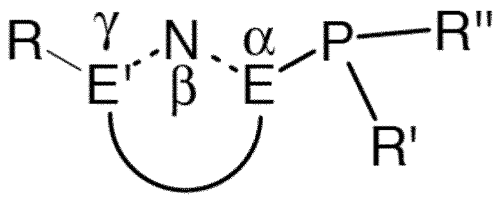

**Formel B**

worin bedeutet:

E: ein Kohlenstoff- oder Stickstoffatom;
E': ein Kohlenstoff- oder Stickstoffatom, das nicht mit einem Wasserstoffatom substituiert ist;

gestrichelte Bindung: eine Einfach- oder Doppelbindung;

R: Alkyl-Rest [$CH_3$-$(CH_2)_n$-] (n = 0 - 20), optional verzweigt oder mit Halogenen (F, Cl, Br, I) substituiert, oder Aryl-Rest (insbesondere Phenyl), optional mit Alkyl-Gruppen, Halogenen (F, Cl, Br, I), Silan- (-$SiR^*_3$) (R* definiert wie R1 unten) oder Ethergruppen -OR** (R** definiert wie R1 unten) substituiert, ungesättigte Gruppe, wie z. B. Alkenyl- und Alkinyl-Gruppen, optional mit Alkyl-Gruppen, Halogenen (F, Cl, Br, I), Silan- (-$SiR^{***}_3$) oder Ethergruppen -OR*** (R*** definiert wie R1 unten) substituiert, wobei R kein Wasserstoffatom ist;
R', R": Alkyl-Gruppen [$CH_3$-$(CH_2)_n$-] (n = 0 - 20, bevorzugt n > 6), die auch verzweigt oder cyclisch sein können, oder Aryl- oder Heteroarylgruppen, die optional mit Alkyl-Gruppen, Halogenen (F, Cl, Br, I), Silan- (-$SiR^*_3$) oder Ethergruppen -OR* (R* definiert wie R1) substituiert sind, wobei R' und R" jeweils direkt an dem Phosphoratom des Phosphan-Liganden gebunden sind;
R1: definiert wie R, wobei R1 optional ein Wasserstoffatom ist;

wobei R, R1 optional annelierte Ringsysteme bilden können.

In einer bevorzugten Ausführungsform der Erfindung erhöhen R, R1, R' und/oder R' (sowie die weiter unten definierten Reste R2 und/oder R3) die Löslichkeit des Kupfer(I)komplexes in organischen Lösungsmitteln. Diese Substituenten können auch die Loch- oder die Elektronenleitung des Komplexes erhöhen. Entsprechende Loch- und Elektronenleiter sind dem Fachmann bekannt.

Weiterhin betrifft die Erfindung einen Kupfer(I)-Komplex, der einen ΔE-Abstand zwischen dem untersten Triplett-Zustand und dem darüber liegenden Singulett-Zustand ($\Delta E(S_1$-$T_1)$-Wert) von 50 $cm^{-1}$ bis kleiner als 2000 $cm^{-1}$, bevorzugt bis kleiner als 1500 $cm^{-1}$, mehr bevorzugt bis kleiner als 1000 $cm^{-1}$, besonders bevorzugt bis kleiner als 500 $cm^{-1}$ aufweist. Ein derartiger Kupfer(I)-Komplex hat eine Struktur gemäß Formel A, ohne auf diese Struktur beschränkt zu sein.

Bevorzugt weist der Kupfer(I)-Komplex eine Emissionsquantenausbeute von größer 20 %, bevorzugt größer 40 %, besonders bevorzugt größer 60 % auf, am meisten bevorzugt von größer 80 % auf. Bevorzugt weist der Kupfer(I)-Komplex eine Emissionslebensdauer von höchstens 10 μs, bevorzugt kleiner 6 μs, besonders bevorzugt kleiner 3 μs auf. Bevorzugt weist der Kupfer(I)-Komplex eine Löslichkeit in organischen Lösungsmitteln von mindestens 10 g/l auf.

In einem weiteren Aspekt betrifft die Erfindung die Verwendung eines Kupfer(I)-Komplexes der genannten Art zur Emission von Licht, insbesondere in einer Emitterschicht in einer opto-elektronischen Vorrichtung.

In einem weiteren Aspekt betrifft die Erfindung ein Verfahren zur Herstellung einer opto-elektronischen Vorrichtung, wobei ein Kupfer(I)-Komplex der genannten Art verwendet wird.

Bevorzugt weist das Herstellungsverfahren nass-chemische Schritte auf, insbesondere die Aufbringung eines in einem ersten Lösungsmittel gelösten ersten Kupfer(I)-Komplexes auf einen festen Träger, und die Aufbringung eines in einem zweiten Lösungsmittel gelösten zweiten Kupfer(I)-Komplexes auf den Träger. Dabei ist der erste Kupfer(I)-Komplex nicht in dem zweiten Lösungsmittel löslich ist und der zweite Kupfer(I)-Komplex nicht in dem ersten Lösungsmittel löslich. Der erste Kupfer(I)-Komplex und/oder der zweite Kupfer(I)-Komplex sind bevorzugt ein Kupfer(I)-Komplex nach

Formel A.

Wenn der Kupfer(I)-Komplex keine ausreichende Löslichkeit aufweist, kann die Verarbeitung des Komplexes auch als Dispersion erfolgen.

Optional kann das Verfahren weiterhin den Schritt der Aufbringung eines in dem ersten Lösungsmittel oder in einem dritten Lösungsmittel gelösten dritten Kupfer(I)-Komplexes auf den festen Träger auf, wobei der dritte Kupfer(I)-Komplex ein Kupfer(I)-Komplex nach Formel A ist. In einer bevorzugten Ausführungsform ist die opto-elektronische Vorrichtung eine Weißlicht-OLED, wobei der erste Kupfer(I)-Komplex ein Rotlichtemitter ist, der zweite Kupfer(I)-Komplex ein Grünlichtemitter ist und der dritte Kupfer(I)-Komplex ein Blaulichtemitter ist.

In einem weiteren Aspekt betrifft die Erfindung eine opto-elektronische Vorrichtung aufweisend einen zweikernigen Kupfer(I)-Komplex, der einen $\Delta E$-Abstand zwischen dem untersten Triplett-Zustand und dem darüber liegenden Singulett-Zustand zwischen 50 $cm^{-1}$ und 2500 $cm^{-1}$, bevorzugt zwischen 50 $cm^{-1}$ und 2000 $cm^{-1}$, bevorzugt zwischen 50 $cm^{-1}$ und 1000 $cm^{-1}$, besonders bevorzugt zwischen 50 $cm^{-1}$ und 500 $cm^{-1}$ aufweist. Eine derartige opto-elektronische Vorrichtung weist insbesondere einen Kupfer(I)-Komplex nach Formel A auf.

In einer solchen opto-elektronischen Vorrichtung beträgt der Anteil des Kupfer(I)-Komplexes in einer Emitterschicht der Vorrichtung 2 bis 100 Gew.-%, bevorzugt 5 bis 90 Gew.-% oder 5 bis 100 Gew.-%, bezogen auf das Gesamtgewicht der Emitterschicht. Sofern die opto-elektronische Vorrichtung in Form einer organischen Leuchtdiode (OLED) vorliegt, weist die Emitterschicht bevorzugt einen Kupfer(I)-Komplex Formel A in der Emitterschicht auf, wobei der Anteil des Kupfer(I)-Komplexes in der Emitterschicht zwischen 2 bis 100 Gew.-%, bevorzugt 5 bis 90 Gew.-%, bezogen auf das Gesamtgewicht der Emitterschicht, beträgt.

Der Begriff "opto-elektronische Vorrichtung" bezieht sich vor allem auf organische Leuchtdioden (OLEDs), lichtemittierende elektrochemische Zellen (LEECs oder LECs), OLED-Sensoren, insbesondere nicht hermetisch nach außen abgeschirmten Gas- und Dampf-Sensoren, optische Temperatur-Sensoren, organische Solarzellen (OSCs), organische Feldeffekttransistoren, organische Lasern, organischen Dioden, organischen Photodioden und "down conversion" Systeme.

## Ausführliche Beschreibung der Erfindung

Überraschender Weise wird das oben genannte Ziel der Erfindung durch die hier beschriebenen Kupfer(I)-Komplexe (Cu(I)-Komplexe) erreicht. Das heißt, die Erfindung betrifft die Schaffung und Bereitstellung und Verwendung von Cu(I)-Verbindungen, die insbesondere folgende Eigenschaften zeigen:

- relativ kurze Emissionslebensdauer von nur wenigen $\mu$s,
- hohe Emissionsquantenausbeuten größer als 40 %, bevorzugt von größer als 60 %,
- weitgehende Verhinderung von unerwünschten Geometrie-Veränderungen und
- Singulett-Harvesting.

## Singulett-Harvesting

Von besonderer Bedeutung ist es, das starke Übergangsverbot vom angeregten Triplett-Zustand $T_1$ zum Singulett-Zustand $S_0$ zu lockern und Emitter-Moleküle mit möglichst kurzer Emissionslebensdauer, aber dennoch hoher Emissionsquantenausbeute zu entwickeln. OLEDs unter Verwendung derartiger Emitter zeigen dann ein deutlich geringeres Roll-Off Verhalten der Effizienz und ermöglichen darüber hinaus eine längere Lebensdauer der opto-elektronischen Vorrichtung.

Überraschenderweise lässt sich die oben beschriebene Problematik durch die vorliegende Erfindung lösen, indem Emitter-Moleküle gemäß Formel A zur Verwendung kommen, die bestimmte elektronische Strukturen bzw. vergleichsweise kleine Singulett-Triplett-Energieabstände aufweisen und die erfindungsgemäß den hier für zweikernige Cu(I)-Komplexe gemäß Formel A beschriebenen Singulett-Harvesting-Effekt zeigen. In Fig. 2a ist ein Energieniveauschema für Übergangsmetall-Komplexe mit relativ kleiner oder sich nur in geringem Maße auswirkender Spin-Bahn-Kopplung schematisch dargestellt. Anhand dieses Schemas sollen die photo-physikalischen Elektrolumineszenz-Eigenschaften dieser Moleküle erläutert werden. Die Loch-Elektron-Rekombination, wie sie beispielsweise in einem opto-elektronischen Bauelement erfolgt, führt im statistischen Mittel zu 25 % zur Besetzung des Singulett-Zustandes (1 Singulettpfad) und zu 75 % zur Besetzung des um $\Delta E_1(S_1\text{-}T_1)$ tiefer liegenden Triplett-Zustandes (3 Triplettpfade). Die in den $S_1$-Zustand gelangende Anregung relaxiert aufgrund des Inter-System-Crossing (ISC)-Prozesses, der bei übergangsmetallorganischen Komplexen in der Regel schneller als in $10^{-12}$ s erfolgt, in den $T_1$-Zustand. Die radiative Emissionslebensdauer des Triplett-Zustandes ist für diese Metall-Komplexe der ersten Periode der Übergangsmetalle in der Regel sehr lang (z. B. 100 $\mu$s bis 1000 $\mu$s oder länger). Emitter mit derart langen Abklingzeiten sind kaum für OLED-Anwendungen geeignet.

Erfindungsgemäß lässt sich der Nachteil des oben beschriebenen Standes der Technik vermeiden, indem

Cu(I)-Komplexe gewählt werden, die einen $\Delta E_2(S_1\text{-}T_1)$-Wert zwischen dem untersten angeregten Singulett ($S_1$)- und dem darunter liegenden Triplett ($T_1$)-Zustand von kleiner als 2500 $cm^{-1}$ aufweisen. Das ist durch das in Fig. 2b gezeigte Energieniveaudiagramm für Cu(I)-Komplexe veranschaulicht. Diese Energiedifferenz ist klein genug, um eine thermische Rückbesetzung des $S_1$-Zustandes aus dem $T_1$-Zustand gemäß einer Boltzmann-Verteilung bzw. gemäß der thermischen Energie $k_BT$ zu ermöglichen. Damit kann eine thermisch aktivierte Lichtemission aus dem $S_1$-Zustand erfolgen. Dieser Vorgang läuft gemäß Gleichung (1) ab

$$\mathrm{Int}(S_1 \rightarrow S_0) / \mathrm{Int}(T_1 \rightarrow S_0) = k(S_1) / k(T_1) \exp(-\Delta E(S_1\text{-}T_1)/k_BT) \qquad (1)$$

Hierin stellt $\mathrm{Int}(S_1 \rightarrow S_0) / \mathrm{Int}(T_1 \rightarrow S_0)$ das Intensitätverhältnis der Emission aus dem $S_1$-Zustand und aus dem $T_1$-Zustand dar, $k_B$ ist die Boltzmann-Konstante und T die absolute Temperatur. $k(S_1) / k(T_1)$ ist das Ratenverhältnis der entsprechenden Übergangsprozesse in den elektronischen Grundzustand $S_0$. Für Cu(I)-Komplexe liegt dieses Verhältnis zwischen $10^2$ bis $10^4$. Erfindungsgemäß besonders bevorzugt sind Moleküle mit einem Ratenverhältnis von $10^3$ bis $10^4$. $\Delta E(S_1\text{-}T_1)$ steht für die Energiedifferenz $\Delta E_2(S_1\text{-}T_1)$ gemäß Fig. 2b.

Durch den beschriebenen Prozess der thermischen Rückbesetzung wird aus dem besetzten Triplett ein Emissionskanal über den Singulett-Zustand $S_1$ geöffnet. Da der Übergang aus dem $S_1$- in den $S_0$- Zustand stark erlaubt ist, wird auch die in den Triplett-Zustand gelangende Anregung praktisch vollständig als Lichtemission über den Singulett-Zustand abgestrahlt. Dieser Effekt ist umso ausgeprägter, je kleiner die Energiedifferenz $\Delta E(S_1\text{-}T_1)$ ist. Daher sind Cu(I)-Komplexe bevorzugt, die einen $\Delta E(S_1\text{-}T_1)$-Wert zwischen dem untersten angeregten Singulett- und dem darunter liegenden Triplett-Zustand von kleiner als 1500 $cm^{-1}$, bevorzugt von kleiner als 1000 $cm^{-1}$ und besonders bevorzugt von kleiner als 500 $cm^{-1}$ aufweisen.

Anhand eines Zahlenbeispiels soll dieser Effekt erläutert werden. Bei einer typischen Energiedifferenz von $\Delta E(S_1\text{-}T_1) = 800$ $cm^{-1}$ ergibt sich für Raumtemperaturanwendungen (T = 300 K) mit $k_BT = 210$ $cm^{-1}$ und einem Ratenverhältnis von $10^3$ ein Intensitätsverhältnis gemäß Gleichung (1) von ca. 20. Das heißt, der Singulett-Emissionsprozess dominiert für ein Molekül mit diesen Beispielwerten drastisch.

Die Emissionslebensdauer dieses Beispiel-Moleküls verändert sich auch deutlich. Durch die thermische Rückbesetzung ergibt sich eine mittlere Lebensdauer $\tau_{av}$. Diese lässt sich näherungsweise gemäß Gleichung (2) beschreiben. Auf eine genauere mathematische Beschreibung wird an Hand der weiter unten aufgeführten Gl. (4) eingegangen.

$$\tau_{av} \approx \tau(S_1) \cdot \exp(\Delta E(S_1\text{-}T_1) / k_BT) \qquad (2)$$

Hierin ist $\tau(S_1)$ die Fluoreszenzlebensdauer ohne Rückbesetzung und $\tau_{av}$ die Emissionslebensdauer, die bei Öffnung des Rückbesetzungskanals durch die beiden Zuständе $T_1$ und $S_1$ bestimmt wird (Siehe Fig. 2b). Die anderen Größen wurden oben definiert.

Gleichung (2) soll wieder durch ein Zahlenbeispiel erläutert werden. Für die angenommene Energiedifferenz von $\Delta E(S_1\text{-}T_1) = 800$ $cm^{-1}$ und einer Abklingzeit des fluoreszierenden $S_1$ - Zustandes von 50 ns ergibt sich eine Emissionsabklingzeit (der beiden Zustände) von $\tau_{av} \approx 2$ $\mu$s. Diese Abklingzeit ist kürzer, als die der meisten sehr guten Ir(III)- oder Pt(II)-Triplett-Emitter.

Zusammenfassend lassen sich also unter Verwendung dieses hier erstmals für zweikernige Cu(I)-Komplexe beschriebenen Singulett-Harvesting-Verfahrens im Idealfall nahezu sämtliche, d. h. maximal 100 % der Exzitonen erfassen und über eine Singulett-Emission in Licht umwandeln. Darüber hinaus gelingt es, die Emissionsabklingzeit drastisch unter den Wert der reinen Triplett-Emission von Cu(I)-Komplexen, die in der Regel bei einigen hundert $\mu$s bis ms liegt, zu verkürzen. Daher ist die erfindungsgemäße Verwendung entsprechender Komplexe für opto-elektronische Bauelemente besonders geeignet.

Die erfindungsgemäßen zweikernigen Cu(I)-Komplexe mit den oben beschriebenen Eigenschaften, d. h. u. a. mit kleiner Singulett-Triplett-Energiedifferenz $\Delta E(S_1\text{-}T_1)$, sind bevorzugt mit der unten angegebenen generellen Formel A zu beschreiben. Die elektronischen Übergänge, die das optische Verhalten dieser Cu(I)-Komplexe steuern, weisen einen ausgeprägten Metall-zu-Ligand-Charge-Transfer Charakter auf. Mit diesem Übergangstyp ist ein relativ kleiner Wert des - dem Fachmann bekannten - quantenmechanischen Austauschintegrals verbunden. Damit resultiert dann die gewünschte kleine Energiedifferenz $\Delta E(S_1\text{-}T_1)$.

Die Erfindung betrifft in einem weiteren Aspekt ein Verfahren zur Auswahl von Cu(I)-Komplexen, deren $\Delta E(S_1\text{-}T_1)$-Wert zwischen dem untersten angeregten Singulett- ($S_1$) und dem darunter liegenden Triplett-Zustand ($T_1$) kleiner als 2500 $cm^{-1}$, bevorzugt kleiner als 1500 $cm^{-1}$, besonders bevorzugt kleiner als 1000 $cm^{-1}$, ganz besonders bevorzugt kleiner 500 $cm^{-1}$ ist.

Die Bestimmung des $\Delta E(S_1\text{-}T_1)$-Wertes kann sowohl durch quantenmechanische Berechnungen mittels im

Stand der Technik bekannten Computerprogrammen (z. B. mittels Turbomole-Programmen unter Ausführung von TDDFT- und unter Berücksichtigung von CC2-Rechnungen) oder - wie weiter unten erläutert wird - experimentell durchgeführt werden.

Die Energiedifferenz $\Delta E(S_1\text{-}T_1)$, insbesondere der durch die Formel A beschriebenen Komplexe, lässt sich näherungsweise quantenmechanisch durch das mit dem Faktor 2 multiplizierte sogenannte Austauschintegral beschreiben. Dessen Wert hängt direkt ab von der Ausgeprägtheit des sogenannten Charge-Transfer-Charakters unter Beteiligung der Metall-d-Orbitale und der Liganden-$\pi^*$-Orbitale. Das heißt, ein elektronischer Übergang zwischen den verschiedenen Orbitalen repräsentiert einen Metall-zu-Ligand-Charge-Transfer (CT)-Übergang. Je geringer die Überlappung der oben beschriebenen Molekülorbitale ist, desto ausgeprägter ist der elektronische Charge-Transfer Charakter. Das ist dann mit einer Abnahme des Austausch-Integrals und somit einer Abnahme der Energiedifferenz $\Delta E(S_1\text{-}T_1)$ verbunden. Aufgrund dieser photophysikalischen (quantenmechanischen) Eigenschaften lassen sich die erfindungsgemäßen Energiedifferenzen mit $\Delta E(S_1\text{-}T_1)$ kleiner 2500 $cm^{-1}$ oder kleiner 1500 $cm^{-1}$ oder kleiner 1000 $cm^{-1}$ oder sogar kleiner 500 $cm^{-1}$ erreichen.

Die Bestimmung des $\Delta E(S_1\text{-}T_1)$-Wertes kann experimentell folgendermaßen erfolgen:

Für einen vorgegebenen Cu(I)-Komplex lässt sich der Energieabstand $\Delta E(S_1\text{-}T_1)$ unter Verwendung der oben angegebenen Gleichung (1) einfach bestimmen. Eine Umformung ergibt:

$$\ln\{Int(S_1 \rightarrow S_0)/Int(T_1 \rightarrow S_0)\} = \ln\{k(S_1)/k(T_1)\} - (\Delta E(S_1\text{-}T_1)/k_B)(1/T) \qquad (3)$$

Für die Messung der Intensitäten $Int(S_1 \rightarrow S_0)$ und $Int(T_1 \rightarrow S_0)$ kann jedes handelsübliche Spektralphotometer verwendet werden. Eine graphische Auftragung der bei verschiedenen Temperaturen gemessenen (logarithmierten) Intensitätsverhältnisse $\ln\{Int(S_1 \rightarrow S_0)/Int(T_1 \rightarrow S_0)\}$ gegen den Kehrwert der absoluten Temperatur T ergibt in der Regel eine Gerade. Die Messung wird in einem Temperaturbereich von Raumtemperatur (300 K) bis 77 K oder bis 4,2 K durchgeführt, wobei die Temperatur mittels eines Kryostaten eingestellt wird. Die Intensitäten werden aus den (korrigierten) Spektren bestimmt, wobei $Int(S_1 \rightarrow S_0)$ bzw. $Int(T_1 \rightarrow S_0)$ die integrierten Fluoreszenz- bzw. Phosphoreszenz-Bandenintensitäten repräsentieren, welche sich mittels der zum Spektralphotometer gehörenden Programme bestimmen lassen. Die jeweiligen Übergänge (Bandenintensitäten) lassen sich leicht identifizieren, da die Triplett-Bande bei niedrigerer Energie liegt als die Singulett-Bande und mit sinkender Temperatur an Intensität gewinnt. Dabei werden die Messungen in sauerstofffreien verdünnten Lösungen (ca. $10^{-2}$ mol $L^{-1}$) oder an dünnen Filmen aus den entsprechenden Molekülen oder an mit den entsprechenden Molekülen dotierten Filmen durchgeführt. Verwendet man als Probe eine Lösung, so empfiehlt es sich, ein Lösemittel bzw. Lösemittelgemisch zu verwenden, das bei tiefen Temperaturen Gläser bildet, wie 2-Methyltetrahydrofuran, Butyronitril, Toluol, Ethanol oder aliphatische Kohlenwasserstoffe. Verwendet man als Probe einen Film, so eignet sich die Verwendung einer Matrix mit einer deutlich größeren Singulett- sowie Triplett-Energie als die der Cu(I)-Komplexe (Emittermoleküle), z. B. PMMA (Polymethylmethacrylat). Dieser Film kann aus Lösung aufgebracht werden.

Die Geradensteigung beträgt $-\Delta E(S_1\text{-}T_1)/k_B$. Mit $k_B = 1{,}380\ 10^{-23}\ JK^{-1} = 0{,}695\ cm^{-1}\ K^{-1}$ lässt sich der Energieabstand direkt bestimmen.

Eine einfache, näherungsweise Abschätzung des $\Delta E(S_1\text{-}T_1)$-Wertes kann auch dadurch vorgenommen werden, dass bei tiefer Temperatur (z. B. 77 K oder 4,2 K unter Verwendung eines Kryostaten) die Fluoreszenz- und Phosphoreszenz-Spektren registriert werden. Der $\Delta E(S_1\text{-}T_1)$-Wert entspricht dann in Näherung der Energiedifferenz zwischen den hochenergetischen Anstiegsflanken der Fluoreszenz- bzw. Phosphoreszenz-Bande.

Ein anderes Bestimmungsverfahren für den $\Delta E(S_1\text{-}T_1)$-Wert ist durch Messung der Emissionsabklingzeiten mit einem handelsüblichen Messgerät gegeben. Hierbei wird die Emissionslebensdauer $\tau_{av}$ als Funktion der Temperatur mit Hilfe eines Kryostaten für den Bereich zwischen 4,2 K oder z. B. 77 K und 300 K gemessen. Unter Verwendung der Formel (4) und der bei tiefer Temperatur gemessenen Emissionslebensdauer für den Triplett-Zustand $\tau(T_1)$ lässt sich ein Fit der Messwerte mit der Formel (4) durchführen, und man erhält den $\Delta E(S_1\text{-}T_1)$-Wert. (Der $\tau(T_1)$-Wert ist häufig durch das sich bei der Auftragung der Messwerte ergebene Plateau bestimmt. Falls sich eine Ausbildung eines derartigen Plateaus zeigt, ist in der Regel eine Kühlung auf 4,2 K nicht mehr erforderlich. Ein entsprechendes Beispiel ist in Figur 5 wiedergegeben.)

$$\tau_{av} = \frac{3 + \exp\left(-\frac{\Delta E(S_1 - T_1)}{k_B T}\right)}{\frac{3}{\tau(T_1)} + \frac{1}{\tau(S_1)}\exp\left(-\frac{\Delta E(S_1 - T_1)}{k_B T}\right)} \quad (4)$$

Je ausgeprägter der CT-Charakter eines organischen Moleküls ist, desto stärker verändern sich die elektronischen Übergangsenergien als Funktion der Lösungsmittelpolarität. So gibt bereits eine ausgeprägte Polaritätsabhängigkeit der Emissionsenergien einen Hinweis auf das Vorliegen kleiner $\Delta E(S_1\text{-}T_1)$-Werte.

**Stabilisierung der Molekularstruktur**

Vierfach koordinierte Cu(I) Komplexe weisen im elektronischen Grundzustand eine annähernd tetraedrische Koordination des Metallatoms auf. Bei Anregung in einen elektronischen angeregten Zustand mit ausgeprägtem Metall-zu-Ligand-Charge-Transfer Charakter und der damit verbundenen partiellen (weiteren) Oxidierung des Metallatoms kann es zu wesentlichen Veränderungen der Geometrie des Komplexes in Richtung einer "Planarisierung" kommen. Dieser Prozess liefert einen sehr effektiven Mechanismus für das Löschen (Quenchen) der Lumineszenz und sollte daher durch eine Stabilisierung der Molekülstruktur zumindest weitgehend unterbunden werden.

In den erfindungsgemäßen zweikernigen Kupfer(I)-Komplexen wird dieser Löschmechanismus durch die sehr starre Molekülstruktur sehr stark eingeschränkt oder fast vollständig unterbunden.

**Chemische Leitstruktur**

Der zu erfindungsgemäße Emitter der Formel **A** weist folgende Merkmale auf:

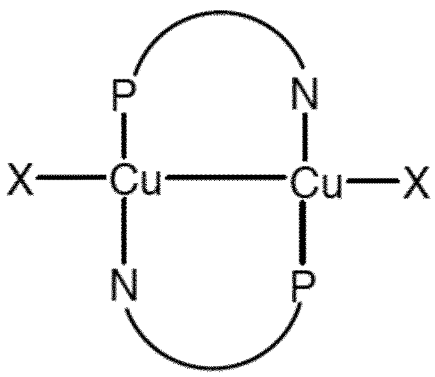

**Formel A**

- Bei P∩N handelt es sich um einen mit einem N-Heterocyclus substituierten Phosphanliganden.
- X = Cl, Br, I, SCN, CN, Alkinyl (R*-≡) (R* definiert wie R unten).

P∩N-Phosphan-Liganden bilden mit CuX (X = Cl, Br, I) zweikernige Komplexe der Stöchiometrie Ligand:Cu = 3:2. Überraschender Weise ergibt die Substitution der Pyridin-Einheit in der 6-Position mit einer Methylgruppe eine 1:1 Stöchiometrie, die sich unabhängig vom Verhältnis und CuX ausbildet. So entsteht bei der Reaktion von P∩N-Ligand mit Cu(I)X (X = Cl, Br, I), bevorzugt in Dichlormethan, bevorzugt bei Raumtemperatur, der zweikernige 2:2-Komplex $Cu_2X_2(P\cap N)_2$, in dem die zwei Cu-Atome durch zwei P∩N-Liganden überbrückt werden. Der Grund liegt in der sterischen Überfrachtung der Ligandenperipherie, die die Koordinierung eines weiteren Liganden wirkungsvoll verhindert. Es findet sich kein Nachweis, der die Ausbildung einer 3:2-Spezies stützt, die durch Umlagerung in den Komplex der Formel A übergeht. Ebenso wenig ist eine Überführung eines bekannten 3:2-Komplexes ohne Substitution in ortho-Position zum N-Atom in eine 2:2-Struktur möglich; nur bei Anwesenheit eines Substituenten in ortho-Position zum N-Atom bilden sich zweikernige Komplexe mit kurzen Cu-Cu-Abständen aus (mit X = Cl: 3.078 Å; X = Br: 2.666 Å; X = I: 2.666 Ä). Dieser Strukturtyp repräsentiert eine relativ rigide Struktur und erlaubt damit eine ausgeprägte Unterdrückung von unerwünschten Geometrieänderungen in den elektronisch angeregten Zuständen.
Die Summenformel der Komplexe der Formel A ist ähnlich zu bekannten Kupfer(I)-Komplexen $Cu_2X_2(PR^*R_2)_2$ mit X =

Cl, Br, I und R = Alkyl, Alkenyl ,Aryl, etc. und R* = Alkyl, Alkenyl, Aryl, Heteroaryl, etc., während sich die räumliche Struktur davon deutlich unterscheidet, da der P∩N-Ligand als zweizähniger Ligand wirkt und über P und N an Cu koordiniert. Des weiteren liegt im Falle der $Cu_2X_2(PR_3)_2$-Komplexe ein dreifach koordiniertes Cu-Zentrum vor, das aufgrund der trigonal-planaren Struktur anfällig gegenüber koordinierenden Fremdmolekülen wie Lösungsmittelmoleküle oder freie Liganden ist, wodurch die Quantenausbeuten stark vermindert werden können. Zusätzlich resultiert die Komplexierung nur über P in $Cu_2X_2(PR_3)_2$ in einer gewissen Flexibilität der Komplexstruktur und möglichen Dissoziation des einzähnigen P-Liganden, wodurch die Stabilität der Komplexe und die entsprechenden Quantenausbeuten deutlich vermindert sind. Diese Flexibilität der Struktur zeigt sich am Beispiel von $Cu_2I_2(PR_3)_2$ mit R = 4-Diphenylphosphin-1,5-diphenyl-1*H*-1,2,3-triazol, der erst durch Einwirkung von bestimmten Lösungsmitteln wie Essigester aus einer geladenen Komplexstruktur $Cu_3I_2PR_3$ hervorgeht, die wiederum aus einer 3:2-Stöchiometrie der Reaktionspartner $PR_3$-Ligand und CuI erhalten wird. Somit werden letztlich aus einer 3:2-Reaktionsmischung mehrere strukturell und in der Zusammensetzung unterschiedliche Komplexe erhalten, die gegenseitig durch Einwirkung von bestimmten Lösungsmitteln ineinander überführt werden können, was für eine nur geringe Stabilität der Komplexe spricht.

Im Gegensatz dazu ist bei Komplexen der Formel A durch die Wirkung des P∩N-Ligand als zweizähniger Ligand ein vierfach koordiniertes Cu-Zentrum vorhanden, wodurch das Metallzentrum gut gegenüber Fremdmolekülen abgeschirmt ist und durch den Substituenten in der γ-Position verstärkt wird. Dies führt zu einer sehr starren und fixierten Molekülstruktur, bei der Löschprozesse durch Geometrieänderungen weitgehend unterbunden werden, was sich in einer zumeist hohen Quantenausbeute widerspiegelt. Weiterhin zeigt sich die rigide Struktur der Komplexe der Formel A mit einer ausgeprägten Unterdrückung von unerwünschten Geometrieänderungen in den elektronisch angeregten Zuständen in einer geringeren Farbverschiebungen der Emissionen in verschiedenen Komplex-Umgebungen (Feststoff, in Lösung, in Matrix) und geringeren Abnahme der Emissionsquantenausbeuten.

Ein strukturell ähnlicher Komplex $Cu_2(P∩N)_2$ weist aufgrund der neutralen P∩N-Liganden den Nachteil auf, dass der Komplex nicht neutral, sondern zweifach positiv geladen ist, wobei für den Ladungsausgleich nicht-koordinierende negativ geladene Gegenionen notwendig sind. Dies führt z.T. zu Problemen bei der Herstellung und dem Betrieb der üblichen optoelektronischen Bauteile. Beispielweise erschwert das Vorliegen der Komplexe als ionische Verbindungen ihr Lösen in für die OLED-Herstellung geeigneten Lösungsmitteln wie Toluol, Mesitylen, Chlorbenzol, etc., und im Betrieb eines üblichen OLEDs könnten die geladenen Emitter und/oder ihre entsprechenden Gegenionen aufgrund der hohen elektrischen Feldstärken zu unerwünschten Ionenwanderungen führen. Im Gegensatz dazu liegt der Komplex der Formel A als elektrisch neutraler Cu-Komplex vor, da der Ladungsausgleich durch die direkt an den Cu-Atomen koordinierten X-Moleküle gewährleistet wird und der neutrale Komplex somit im elektrischen Feld einer OLED nicht wandert.

**Phosphan-Ligand P∩N**

Bei dem P∩N-Liganden handelt es sich um einen mit einem N-Heterocyclus funktionalisierten Phosphan-Liganden, wobei sich - vom Phosphoratom aus betrachtet -ein Stickstoffatom in der β-Position befindet und das Atom E' in γ-Position nicht mit einem Wasserstoffatom substituiert ist. Bei E und E' handelt es sich entweder um ein Kohlenstoff- oder Stickstoffatom. Die Bindung zu den Kupferatomen erfolgt über das Stickstoffatom in Position β sowie über das Phosphoratom. Die gestrichelten Bindungen sind abhängig vom N-Heterocyclus entweder eine Einfach- oder Doppelbindung. Formel B soll dies verdeutlichen:

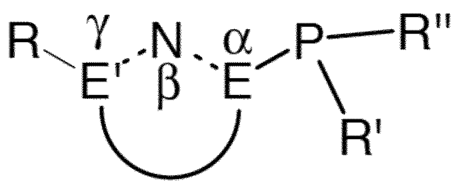

**Formel B**

**Definition des N-Heterocyclus':**

Bei dem N-Heterocyclus handelt es sich bevorzugt um einen in 6-Position mit R substituierten Pyridinrest und weitere N-heterocyclische Sechsringe und deren annelierte Homologe:

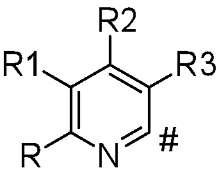 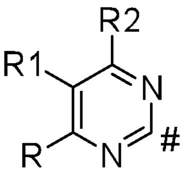 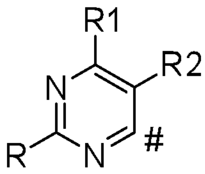 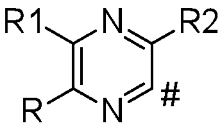 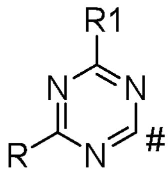

An der mit "#" gekennzeichneten Positionen ist der N-Heterocyclus mit dem Phosphoratom verknüpft.
Bei den Substituenten R kann es sich um einen Alkyl-Rest [$CH_3$-$(CH_2)_n$-] (n = 0 - 20), der auch verzweigt oder mit Halogenen (F, Cl, Br, I) substituiert sein kann oder um einen Aryl-Rest (insbesondere Phenyl) handeln, der mit Alkyl-Gruppen, Halogenen (F, Cl, Br, I), Silan-(-$SiR^*_3$) oder Ethergruppen -OR** (R** definiert wie R1) substituiert sein kann. Ebenso kann es sich bei R um ungesättigte Gruppen wie Alkenyl und Alkinyl-Gruppen handeln, die wiederum mit Alkyl-Gruppen, Halogenen (F, Cl, Br, I), Silan- (-$SiR^{***}_3$) oder Ethergruppen -OR*** (R*** definiert wie R1) substituiert sein können. Bei R soll es sich nicht um ein Wasserstoffatom handeln.
Die Substitutent R1 - R3 sind definiert wie R, außer dass es sich bei diesen Substitutenten auch um Wasserstoffatome handeln kann. Die Substituenten R, R1-R3 können auch zu annelierten Ringsystemen führen.

Einige Beispiele für möglichen N-Heterocyclen sollen die allgemeinen Formeln verdeutlichen:

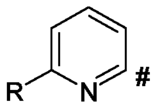 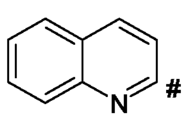 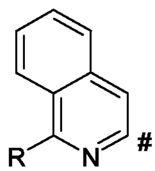 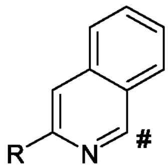

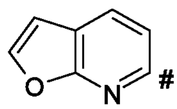 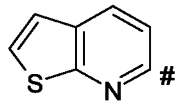 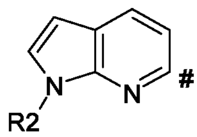 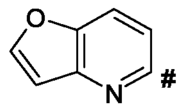 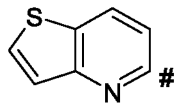 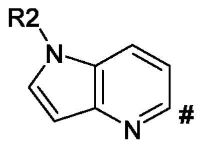

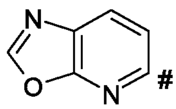 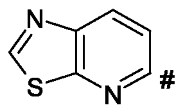 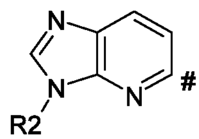

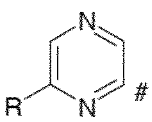 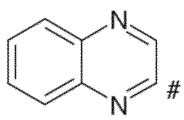 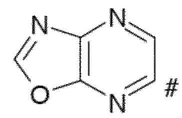 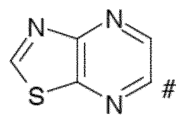 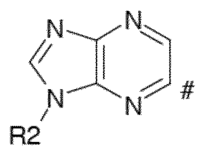

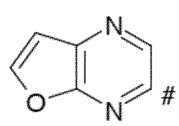 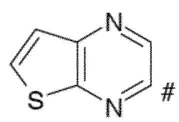 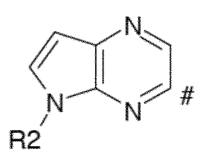 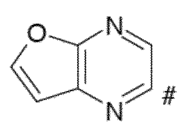 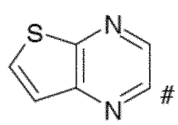 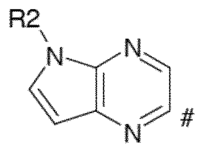

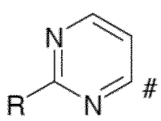 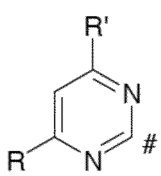 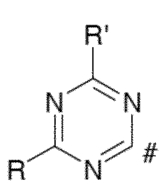 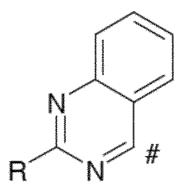

Bei den N-Heterocyclen kann es sich auch um Fünfringe handeln:

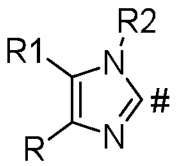
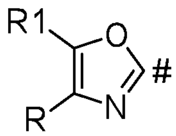
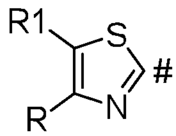
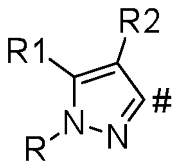

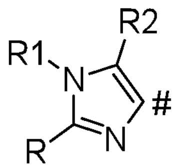
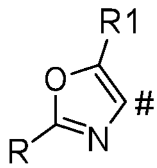
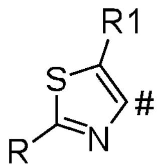

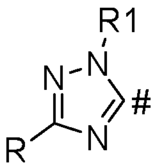
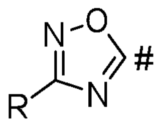
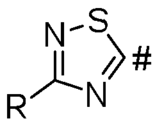
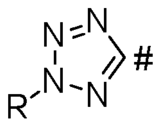

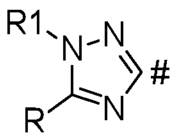
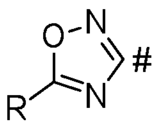
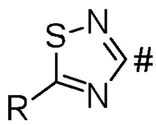
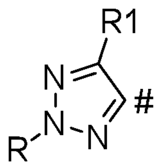

Die Reste R, R1 und R2 sind definiert wie oben.
Bevorzugt sind die folgenden Liganden:

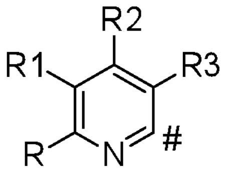
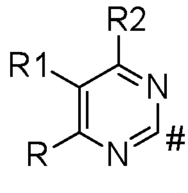
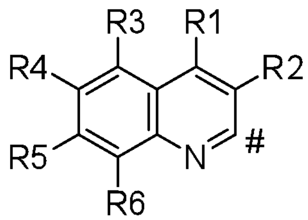

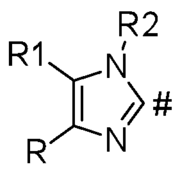
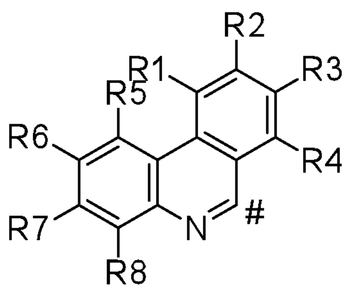

Die Reste R, R1 bis R8 sind definiert wie oben.

**Definition der Rest R' und R":**

Bei den Rest R' und R", die direkt an dem Phosphoratom des Phosphan-Liganden gebunden sind, handelt es sich um Alkyl-Gruppen $[CH_3-(CH_2)_n-]$ (n = 0 - 20, bevorzugt n > 6), die auch verzweigt oder cyclisch sein können, oder um Aryl- und Heteroarylgruppen, die mit Alkyl-Gruppen, Halogenen (F, Cl, Br, I), Silan- ($-SiR^*_3$) oder Ethergruppen -OR*

(R* definiert wie R1) substituiert sein können. Besonders bevorzugt sind Phenylgruppen.

**Löslichkeit**

Bei einer Herstellung von opto-elektronischen Bauteilen mittels nass-chemischer Prozesse ist es vorteilhaft, die Löslichkeit gezielt einzustellen. Hierdurch kann das Auf- bzw. Anlösen einer bereits aufgebrachten Schicht vermieden werden. Durch das Einbringen spezieller Substituenten können die Löslichkeitseigenschaften stark beeinflusst werden. Dadurch ist es möglich, orthogonale Lösungsmittel zu verwenden, die jeweils nur die Substanzen des aktuellen Verarbeitungsschrittes lösen, aber nicht die Substanzen der darunter liegenden Schicht(en). Zu diesem Zweck können die Substitutenten R, R1-R3, R' und R" so gewählt werden, dass sie eine Abstimmung der Löslichkeiten erlauben. Folgende Möglichkeiten zur Auswahl entsprechender Substituenten sind gegeben:

**Löslichkeit in unpolaren Medien**

Unpolare Substitutenten R, R1-R3, R' und R" erhöhen die Löslichkeit in unpolaren Lösungsmitteln und erniedrigen die Löslichkeit in polaren Lösungsmitteln. Unpolare Gruppen sind z. B. Alkylgruppen $[CH_3-(CH_2)_n-]$ (n = 1 - 30), auch verzweigte, substituierte Alkylgruppen, z. B. mit Halogenen. Hierbei sind besonders hervorzuheben: teil- oder perfluorierte Alkylgruppen sowie perfluorierte Oligo- und Polyether, z. B. $[-(CF_2)_2-O]_n-$ und $(-CF_2-O)_n-$ (n = 2 - 500). Weitere unpolare Gruppen sind: Ether -OR*, Thioether -SR*, unterschiedlich substituierte Silane $R^*_3Si-$ (R* = Alkyl oder Aryl), Siloxane $R^*_3Si-O-$, Oligosiloxane $R^{**}(-R_2Si-O)_n$ (R** = R*, n = 2 - 20), Polysiloxane $R^{**}(-R^*_2Si-O)_n$ (n > 20); Oligo/polyphosphazene $R^{**}(-R^*_2P=N-)_n-$ (n = 1 - 200).

**Löslichkeit in polaren Medien**

Polare Substitutenten R, R1-R3, R' und R" erhöhen die Löslichkeit in polaren Lösungsmitteln. Diese können sein:

- Alkohol-Gruppen: -OH
- Carbonsäure-, Phosphonsäure-, Sulfonsäure-Reste sowie deren Salze und Ester (R* = H, Alkyl, Aryl, Halogen; Kationen: Alkalimetalle, Ammonium-Salze):
  - COOH, $-P(O)(OH)_2$, $-P(S)(OH)_2$, $-S(O)(OH)_2$, -COOR*, $-P(O)(OR^*)_2$,$-P(S)(OR^*)_2$,$-S(O)(OR^*)_2$, -CONHR*, $-P(O)(NR^*_2)_2$, $-P(S)(NR^*_2)_2$, $-S(O)(NR^*_2)_2$
- Sulfoxide: -S(O)R*, $-S(O)_2R^*$
- Carbonylgruppen: -C(O)R*
- Amine: $-NH_2$, $-NR^*_2$, $-N(CH_2CH_2OH)_2$,
- Hydroxylamine =NOR*
- Oligoester, $-O(CH_2O-)_n$, $-O(CH_2CH_2O-)_n$ (n = 2 - 200)
- Positiv geladene Substituenten: z. B. Ammonium-Salze $-N^+R^*_3X^-$, PhosphoniumSalze $-P^+R^*_3X^-$
- Negativ geladene Substituenten, z. B. Borate $-(BR^*_3)^-$, Aluminate $-(AlR^*_3)^-$ (als Anion kann ein Alkalimetal oder Ammoniumion fungieren).

Um die Anwesenheit frei beweglicher Ionen zu vermeiden, können auch positiv und negativ geladene Substituenten in den Substituenten R, R1-R3, R' und R" vereinigt werden.

**Beispiele**

Allgemeine Synthesevorschrift:

Darstellung der zweikernigen Cu(I)-Komplexe gemäß Formel A.
Das entsprechende Kupferhalogenid wird in Dichlormethan vorgelegt und ein Äquivalent an Phosphanligand wird zugegeben. Die Reaktionsmischung wird bei Raumtemperatur über Nacht gerührt. Nach dem Filtrieren erhält man den Komplex durch Zugabe von $Et_2O$ als feinkristallinen, gelben Niederschlag. Für die Röntgenstrukturanalyse geeignete Kristalle erhält man durch langsame Gasphasendiffusion von $Et_2O$ in die Reaktionslösung.

I. **P∩N* = 6-MePyrPPh$_2$**, 1: **$Cu_2X_2$(6-MePyrPPh$_2$)$_2$, 2a-c**

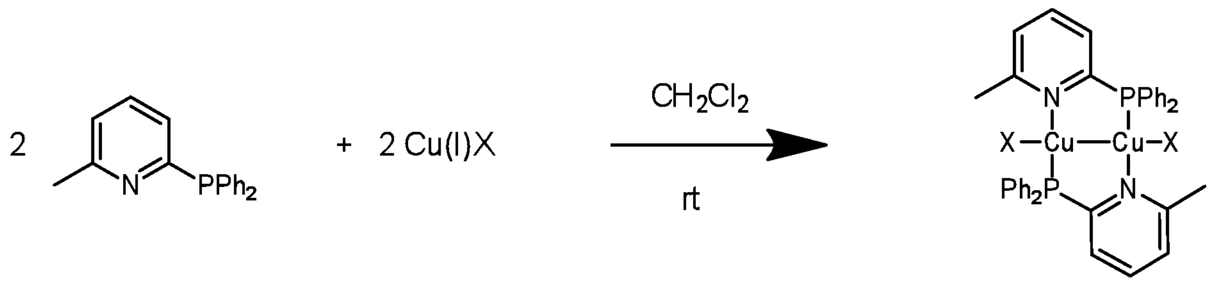


**1**

**2a:** X = Cl
**2b:** X = Br
**2c:** X = I

Tabelle: 1: Elementaranalysen

| | C | | H | | N | |
|---|---|---|---|---|---|---|
| | ber. | gef. | ber. | gef. | ber. | gef. |
| **2a** | 57.45 | 57.44 | 4.29 | 4.30 | 3.72 | 3.63 |
| **2b** | 57.97 | 57.97 | 4.32 | 4.52 | 3.76 | 3.64 |
| **2c** | 46.22 | 45.93 | 3.45 | 3.44 | 2.99 | 3.48 |
| (ber. = berechnet, gef. = gefunden) | | | | | | |

**Photophysikalische Charakterisierung**

In Fig. 3 sind die Molekülstrukturen der drei synthetisierten zweikernigen Cu(I)-Komplexe abgebildet, die sich aus Kristallstrukturbestimmungen ergeben.

In Fig. 4 sind für $Cu_2Cl_2(Ph_2PMepy)_2$ **(2a)** Emissionsspektren für T = 300 K und 77 K und das Anregungsspektrum für T = 300 K wiedergegeben. Fig. 5 zeigt den Temperaturgang der gemessenen Abklingzeit im Bereich von T = 77 K bis 300 K. Unter Verwendung dieser Resultate lässt sich auf das Auftreten des Singulett-Harvesting-Effektes schließen. Bei T = 77 K emittiert nur der energetisch niedriger liegende Triplett-Zustand $T_1$ mit einer (in diesem Fall vergleichsweise kurzen) Abklingzeit von 42 $\mu$s (Fig. 5, Tabelle 3). Mit wachsender Temperatur wird zunehmend der energetisch höher liegende Singulett ($S_1$) Zustand thermisch rückbesetzt. Bei Raumtemperatur beträgt die Abklingzeit 8,2 $\mu$s (Tabelle 2). Das gemessene Abklingverhalten lässt sich durch Gl. (4) beschreiben. Aus einer entsprechenden Fit-Prozedur ergibt sich eine Energiedifferenz zwischen dem Triplett-$T_1$ und dem Singulett-Zustand $S_1$ von 830 $cm^{-1}$. Die intrinsische Abklingzeit des $S_1$ Zustandes ergibt sich zu $\tau(S_1)$ = 0,2 $\mu$s. Diese Ergebnisse sind in Figur 6 zusammengefasst. Auf Grund dieses Prozesses der Rückbesetzung aus dem $T_1$ Zustand, der ein langlebiges Reservoir darstellt, in den kurzlebigen $S_1$ Zustand resultiert eine (gemessene) Zwei-Zustand-System-Abklingzeit von $\tau$(300 K) = 8,2 $\mu$s (Tabelle 2). Außerdem erfolgt mit der thermisch induzierten Besetzung des energetisch höher liegenden $S_1$ Zustandes eine Blau-Verschiebung der Emission (Verschiebung zu höherer Energie) (Fig. 4). Auch dieses Ergebnis weist deutlich auf das Vorliegen des Singulett-Harvesting beim erfindungsgemäßen zweikernigen Cu(I)-Komplex $Cu_2Cl_2(Ph_2PMepy)_2$ hin. Es sei besonders herausgestellt, dass die für diese Verbindung gemessene Emissionsquantenausbeute mit $\phi_{PL}$(300 K) = 92 % außerordentlich hoch ist.

Weiterhin zeigt sich die rigide Struktur der Komplexe der Formel A mit einer ausgeprägten Unterdrückung von unerwünschten Geometrieänderungen in den elektronisch angeregten Zuständen in einer geringeren Farbverschiebungen der Emissionen in verschiedenen Komplex-Umgebungen (Feststoff, als Film, in Matrix) und geringeren Abnahme der Emissionsquantenausbeuten (Figur 19, am Beispiel **2c** gezeigt).

In den Figuren 7 und 8 sowie in den Tabellen 2 und 3 sind die entsprechenden Spektren und Daten für die Komplexe $Cu_2Br_2(Ph_2PMepy)_2$ **(2b)** und $Cu_2I_2(Ph_2PMepy)_2$ **(2c)** zusammengefasst. Aus diesen experimentell ermittelten Resultaten lässt sich auch für diese beiden zweikernigen Komplexe auf das Auftreten eines ausgeprägten Singulett-Harvesting-Effektes schließen.

Tabelle 2: Photophysikalische Daten bei 300 K (Pulverdaten)

| | $\lambda_{max}$(300 K) [nm] | $\phi_{PL}$ (300 K)[b] | $\tau$(300 K)[a] [$\mu$s] | $k^r$(300 K) [$s^{-1}$] | $k^{nr}$(300 K) [$s^{-1}$] |
|---|---|---|---|---|---|
| **2a** | 485 | 0.92 | 8.2 | $1.1x10^5$ | $1.0x10^4$ |
| **2b** | 501 | 0.52 | 12.6 | $4.1x10^4$ | $3.8x10^4$ |
| **2c** | 484 | 0.76 | 7.3[c] | $1.0x10^5$ | $3.3x10^4$ |

Tabelle 3: Photophysikalische Daten bei 77 K (Pulverdaten)

| | $\lambda_{max}$(77 K) [nm] | $\phi_{PL}$(77 K) b | $\tau$(77 K)[a] [$\mu$s] | $k^r$(77 K) [$s^{-1}$] | $k^{nr}$(77 K) [$s^{-1}$] |
|---|---|---|---|---|---|
| **2a** | 510 | 0.97 | 42 | $2.2x10^4$ | $6.6x10^3$ |
| **2b** | 526 | | 88 | | |
| **2c** | 511 | 0.84 | 51[c] (≈160[d]) | $1.6x10^4$ ($5.3x10^3$) | $3.6x10^3$ ($10x10^3$) |

[a] Anregungswellenlänge $\lambda_{exc}$ = 372 nm
[b] Anregungswellenlänge $\lambda_{exc}$ = 400 nm
[c] Die Abklingkurve weicht vom monoexponentiellen Verhalten ab. Die Abklingzeit wurde durch eine biexponentielle Ausgleichkurve bestimmt.
[d]Lange Komponente

**II. P∩N* = 4,6-DiMePyrimPPh$_2$, 3: $Cu_2X_2$(4,6-DiMePyrimPPh$_2$)$_2$, 4a,b**

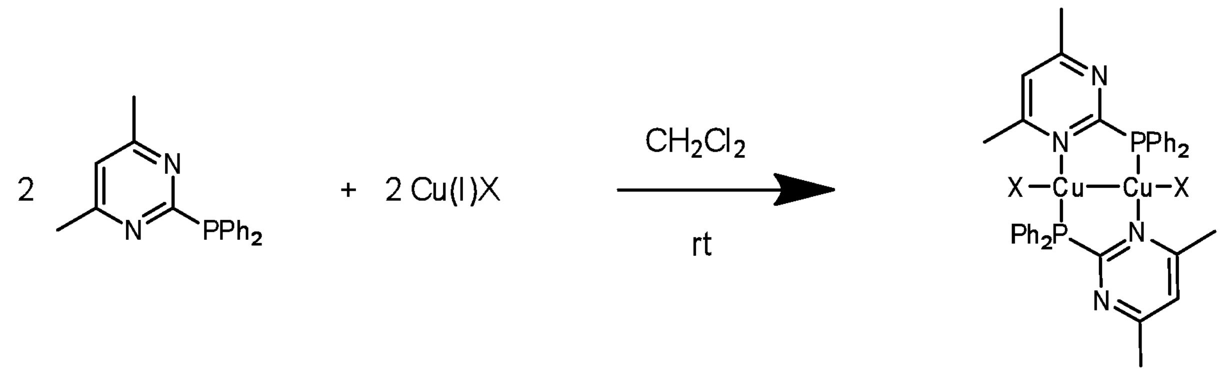


**3**

**4a:** X = I
**4b:** X = Br

Tab. 3: Elementaranalysen

| | C | | H | | N | |
|---|---|---|---|---|---|---|
| | ber. | gef. | ber. | gef. | ber. | gef. |
| **4a** | 44.78 | 44.94 | 3.55 | 3.50 | 5.80 | 5.75 |
| **4b** | 49.61 | 49.49 | 3.93 | 3.90 | 6.43 | 6.26 |
| (ber. = berechnet, gef. = gefunden) | | | | | | |

## Photophysikalische Charakterisierung

Das Emissionsspektrum von **4a** bei 298 K ist in Fig. 9 gezeigt.
Das Emissionsspektrum von **4a** bei 77 K ist in Fig. 9 gezeigt.
Die Emissionsquantenausbeute von **4a** bei 298 K beträgt 26% (gemessen mit Hamamatsu C9920-02G) Die Emissionslebensdauer von **4a** beträgt 3 μs (Horiba Fluoromax 4 mit TCSPC).
Der $\Delta E(S_1\text{-}T_1)$-Wert von **4a** beträgt 290 $cm^{-1}$ (ermittelt durch den Energieunterschied der Fluoreszenz- und Phosphorezenzbande bei 298 K bzw. 77 K).

Das Emissionsspektrum von **4b** bei 298 K ist in Fig. 10 gezeigt.
Das Emissionsspektrum von **4b** bei 77 K ist in Fig. 10 gezeigt.
Die Emissionsquantenausbeute von **4b** bei 298 K beträgt 21% (gemessen mit Hamamatsu C9920-02G)
Die Emissionslebensdauer von **4b** beträgt 5 μs (Horiba Fluoromax 4 mit TCSPC).
Der ΔE(S1-T1)-Wert von **4b** beträgt 660 cm-1 (ermittelt durch den Energieunterschied der Fluoreszenz- und Phosphorezenzbande bei 298 K bzw. 77 K).

## III. P∩N* = 4-iBu-6-MePyrimPPh$_2$, 5: Cu$_2$X$_2$(4,6-DiMePyrimPPh$_2$)$_2$, 6a,b

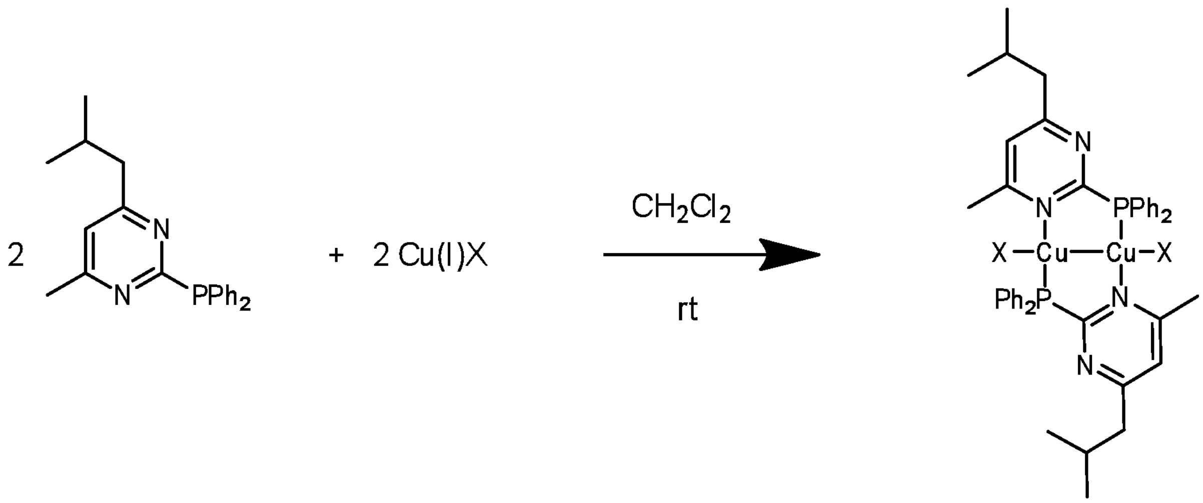


**5**

**6a:** X = Br
**6b:** X = Cl

## Photophysikalische Charakterisierung

Das Emissionsspektrum von 6a bei 298 K ist in Fig. 11 gezeigt.
Das Emissionsspektrum von 6a bei 77 K ist in Fig. 11 gezeigt.
Die Emissionsquantenausbeute von 6a bei 298 K beträgt 24% (gemessen mit Hamamatsu C9920-02G)
Die Emissionslebensdauer von **6a** beträgt 15 μs (Horiba Fluoromax 4 mit TCSPC).
Der ΔE(S1-T1)-Wert von **6a** beträgt 450 $cm^{-1}$ (ermittelt durch den Energieunterschied der Fluoreszenz- und Phosphorezenzbande bei 298 K bzw. 77 K).

Das Emissionsspektrum von **6b** bei 298 K ist in Fig. 12 gezeigt.
Das Emissionsspektrum von **6b** bei 77 K ist in Fig. 12 gezeigt.
Die Emissionsquantenausbeute von **6b** bei 298 K beträgt 22% (gemessen mit Hamamatsu C9920-02G)
Die Emissionslebensdauer von **6b** beträgt 11 μs (Horiba Fluoromax 4 mit TCSPC).
Der ΔE(S1-T1)-Wert von **6b** beträgt 220 cm-1 (ermittelt durch den Energieunterschied der Fluoreszenz- und Phosphorezenzbande bei 298 K bzw. 77 K).

## IV. P∩N* = 4-Me-1-PentImidazolPPh$_2$, 7: Cu$_2$I$_2$(4-Me-1-PentImidazolPPh$_2$)$_2$, 8a

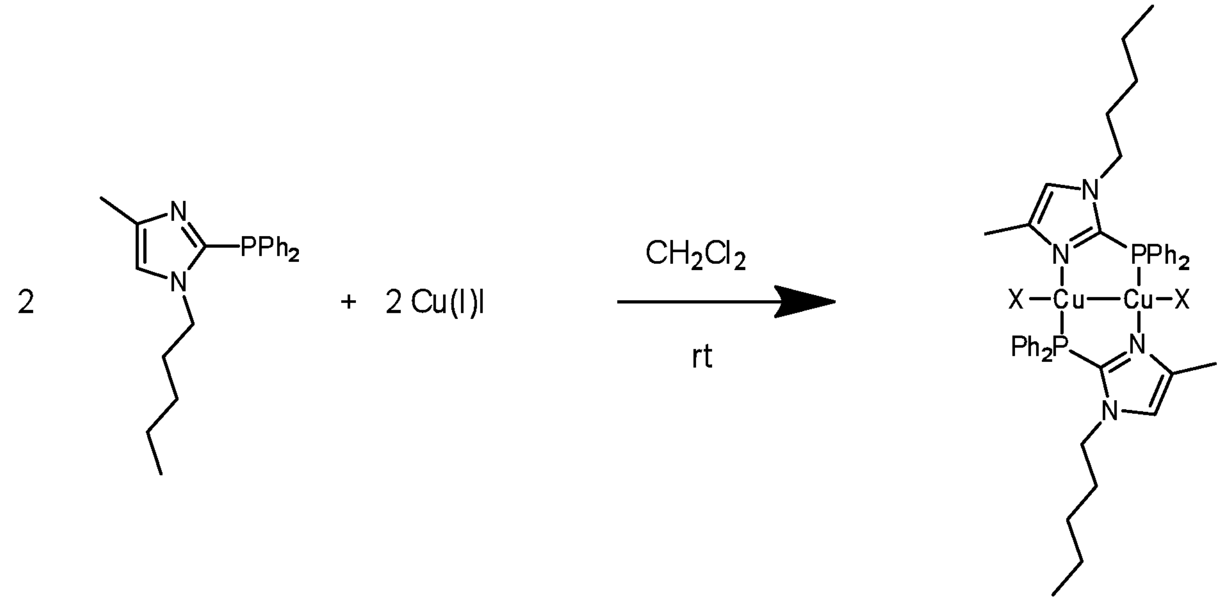


**7** **8a:** X = I

Tab. 4: Elementaranalyse

| | C | | H | | N | |
|---|---|---|---|---|---|---|
| | ber. | gef. | ber. | gef. | ber. | gef. |
| **8a** | 47.87 | 47.83 | 4.78 | 4.68 | 5.32 | 5.29 |
| (ber. = berechnet, gef. = gefunden) | | | | | | |

**Photophysikalische Charakterisierung**

Das Emissionsspektrum von **8a** bei 298 K ist in Fig. 13 gezeigt.
Das Emissionsspektrum von **8a** bei 77 K ist in Fig. 13 gezeigt.
Die Emissionsquantenausbeute von **8a** bei 298 K beträgt 27% (gemessen mit Hamamatsu C9920-02G)
Die Emissionslebensdauer von **8a** beträgt 4 µs (Horiba Fluoromax 4 mit TCSPC).
Der ΔE(S1-T1)-Wert von **8a beträgt** 1730 **cm-1** (ermittelt durch den Energieunterschied der Fluoreszenz- und Phosphorezenzbande bei 298 K bzw. 77 K).

**V. P∩N* = 4-Me-1-TolylImidazolPPh$_2$, 9: Cu$_2$I$_2$(4-Me-1-TolylImidazolPPh$_2$)$_2$, 10a**

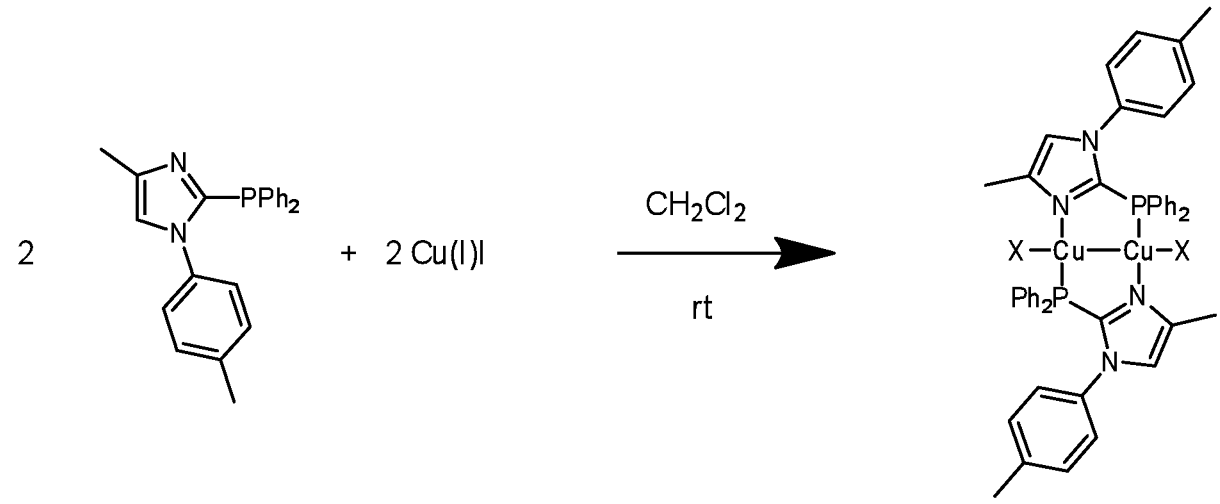


**9**

**10a:** X = I

Tab. 5: Elementaranalyse

| | C | | H | | N | |
|---|---|---|---|---|---|---|
| | ber.[a] | gef. | ber.[a] | gef. | ber.[a] | gef. |
| **10a** | 47.89 | 47.73 | 3.76 | 3.62 | 4.75 | 4.55 |
| [a] $Cu_2I_2$(4-Me-1-TolylImidazolPPh$_2$)$_2$ x 1 Molekül $CH_2Cl_2$ (ber. = berechnet, gef. = gefunden) | | | | | | |

**Photophysikalische Charakterisierung**

Das Emissionsspektrum von **10a** bei 298 K ist in Fig. 14 gezeigt.
Das Emissionsspektrum von **10a** bei 77 K ist in Fig. 14 gezeigt.
Die Emissionsquantenausbeute von **10a** bei 298 K beträgt 40% (gemessen mit Hamamatsu C9920-02G)
Die Emissionslebensdauer von **10a** beträgt 9 $\mu$s (Horiba Fluoromax 4 mit TCSPC).
Der $\Delta E(S_1-T_1)$-Wert von **10a** beträgt 930 cm-1 (ermittelt durch den Energieunterschied der Fluoreszenz- und Phosphorezenzbande bei 298 K bzw. 77 K).

**VI. P$\cap$N* = QuinolinPPh$_2$, 11: Cu$_2$I$_2$(QuinolinPPh$_2$)$_2$,12a-c**

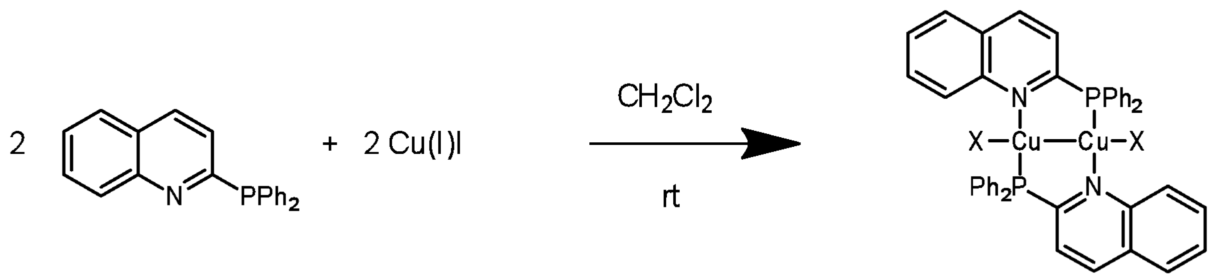


**11**

**12a:** X = I
**12b**: X = Br
**12c**: X = Cl

Tab. 6: Elementaranalysen

| | C | | H | | N | |
|---|---|---|---|---|---|---|
| | ber. | gef. | ber. | gef. | ber. | gef. |
| **12a** | 50.07 | 49.92 | 3.20 | 3.21 | 2.78 | 2.64 |
| **12b**[a] | 54.28 | 54.39 | 3.50 | 3.44 | 3.00 | 2.78 |
| **12c**[b] | 59.99 | 59.96 | 3.87 | 3.78 | 3.31 | 3.21 |
| [a] $Cu_2Br_2(QuinolinPPh_2)_2$ x ¼ Molekül $CH_2Cl_2$<br>[b] $Cu_2Cl_2(QuinolinPPh_2)_2$ x ¼ Molekül $CH_2Cl_2$<br>(ber. = berechnet, gef. = gefunden) | | | | | | |

**Photophysikalische Charakterisierung**

Das Emissionsspektrum von **12b** bei 298 K ist in Fig. 15 gezeigt.
Das Emissionsspektrum von **12b** bei 77 K ist in Fig. 15 gezeigt.
Die Emissionslebensdauer von **12b** beträgt 11 µs (Horiba Fluoromax 4 mit TCSPC).
Der ΔE(S1-T1)-Wert von **12b** beträgt 380 cm-1 (ermittelt durch den Energieunterschied der Fluoreszenz- und Phosphorezenzbande bei 298 K bzw. 77 K).

Das Emissionsspektrum von **12c** bei 298 K ist in Fig. 16 gezeigt.
Das Emissionsspektrum von **12c** bei 77 K ist in Fig. 16 gezeigt.
Die Emissionsquantenausbeute von **12c** bei 298 K beträgt 24% (gemessen mit Hamamatsu C9920-02G)
Die Emissionslebensdauer von **12c** beträgt 16 µs (Horiba Fluoromax 4 mit TCSPC).
Der ΔE(S1-T1)-Wert von **12c** beträgt 330 cm-1 (ermittelt durch den Energieunterschied der Fluoreszenz- und Phosphorezenzbande bei 298 K bzw. 77 K).

**VII. P∩N* = $PhenanthridinPPh_2$, 13: $Cu_2I_2(PhenanthridinPPh_2)_2$, 14a**

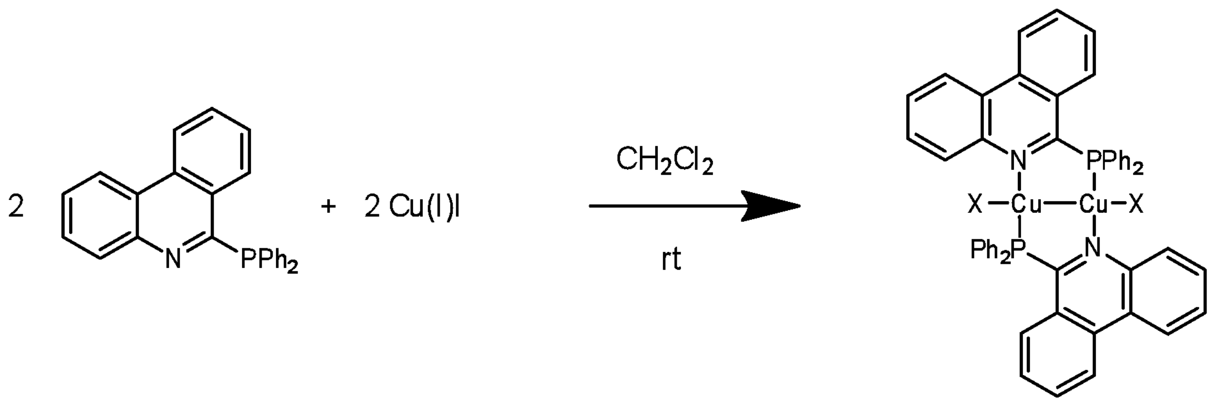


**13** **14a:** X = I

Tab. 7: Elementaranalyse

| | C | | H | | N | |
|---|---|---|---|---|---|---|
| | ber. | gef. | ber. | gef. | ber. | gef. |
| **14a** | 54.22 | 54.36 | 3.28 | 3.75 | 2.53 | 4.18 |
| (ber. = berechnet, gef. = gefunden) | | | | | | |

**Photophysikalische Charakterisierung**

Das Emissionsspektrum von **14a** bei 298 K ist in Fig. 17 gezeigt. Die Emissionslebensdauer von **14a** beträgt 8 μs (Horiba Fluoromax 4 mit TCSPC).

**VIII. P∩N* = 4-Et-QuinazolinPPh$_2$, 15: $Cu_2I_2$(4-Et-QuinazolinPPh$_2$)$_2$,16a**

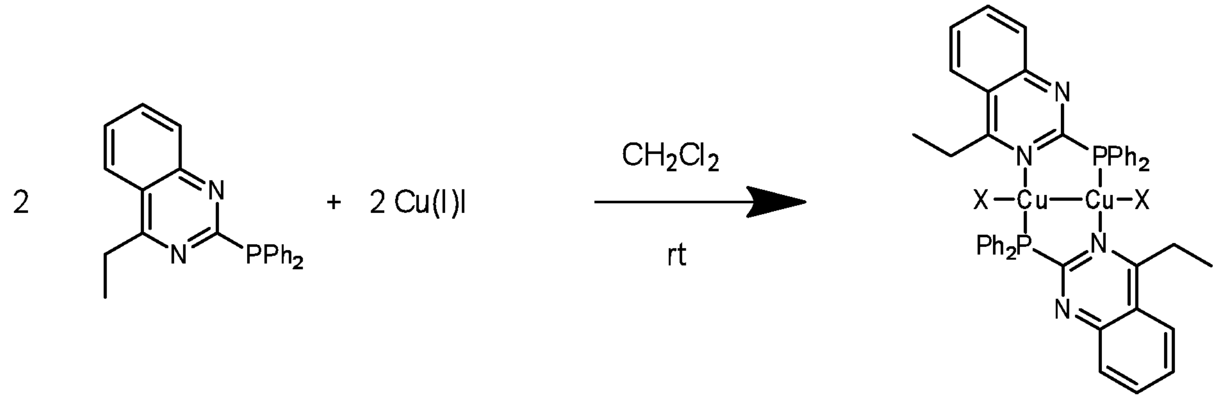


**15**

**16a:** X = I

Tab. 8: Elementaranalyse

| | C | | H | | N | |
|---|---|---|---|---|---|---|
| | ber. | gef. | ber. | gef. | ber. | gef. |
| **16a** | 49.59 | 49.59 | 3.59 | 3.82 | 5.26 | 5.08 |
| (ber. = berechnet, gef. = gefunden) | | | | | | |

**Photophysikalische Charakterisierung**

Das Emissionsspektrum von **16a** bei 298 K ist in Fig. 18 gezeigt.
Das Emissionsspektrum von **16a** bei 77 K ist in Fig. 18 gezeigt.
Die Emissionslebensdauer von **16a** beträgt 9 μs (Horiba Fluoromax 4 mit TCSPC).
Der ΔE(S1-T1)-Wert von **16a** beträgt 200 cm-1 (ermittelt durch den Energieunterschied der Fluoreszenz- und Phosphorezenzbande bei 298 K bzw. 77 K).

**Figuren**

**Figur 1:** Prinzipieller, schematische Aufbau eines OLEDs. Die Abbildung ist nicht maßstabsgerecht gezeichnet.
**Figur 2:** Erläuterungen des Elektro-Lumineszenz-Verhaltens **a** für Übergangsmetall-Komplexe mit kleiner oder sich nur in geringem Maße auswirkender Spin-Bahn-Kopplung und **b** für erfindungsgemäße zweikernige Cu(I)-Komplexe. Der in **a** für $\tau(T_1)$ angegebene Wert repräsentiert ein Beispiel.
**Figur 3:** Molekülstrukturen der dimeren Kupferkomplexe (6-Me-py)PPh$_2$)$_2$$Cu_2X_2$ (X = Cl, Br, I). Diese Strukturen resultieren aus Kristallstruktur-Bestimmungen.
**Figur 4:** Anregungsspektrum und Emissonsspektren von $Cu_2Cl_2$((6-Me-py)PPh$_2$)$_2$. Die gepunktete Kurve symbolisiert den ungefähren Verlauf der $S_0$ - $S_1$ Anregung. In dem Diagramm sind außerdem die Werte für die Emissionsquantenausbeute und die gemessene Emissionsabklingzeit für T = 300 K angegeben.
**Figur 5:** Temperaturverlauf der Emissionslebensabklingzeit von $Cu_2Cl_2$((6-Me-py)PPh$_2$)$_2$. Die angegebenen Para-

meter ergeben sich aus seiner Anpassung gemäß Gl. 4 an die experimentellen Daten.

**Figur 6:** Energieniveauschema für die untersten Energieniveaus von $Cu_2Cl_2((6\text{-Me-py})PPh_2)_2$. Die für den $T_1$ Zustand angegebene gemessene Abklingzeit mit $\tau(T_1)$ = 42 μs gilt für T = 77 K, während der Wert von 0,2 μs die intrinsische Abklingzeit der Fluoreszenz aus dem $S_1$ Zustand repräsentiert.

**Figur 7:** Anregungsspektrum und Emissionsspektren von $Cu_2Br_2((6\text{-Me-py})PPh_2)_2$. Die gepunktete Kurve symbolisiert den ungefähren Verlauf der $S_0$ - $S_1$ Anregung. In dem Diagramm sind außerdem die Werte für die Emissionsquantenausbeute und die gemessene Emissionsabklingzeit für T = 300 K angegeben.

**Figur 8:** Anregungsspektrum und Emissionsspektren von $Cu_2I_2((6\text{-Me-py})PPh_2)_2$. Die gepunktete Kurve symbolisiert den ungefähren Verlauf der $S_0$ - $S_1$ Anregung. In dem Diagramm sind außerdem die Werte für die Emissionsquantenausbeute und die gemessene Emissionsabklingzeit für T = 300 K angegeben.

**Figur 9 - 18:** Emissionsspektren pulverförmiger Proben von **4a, 4b, 6a, 6b, 8a, 10a, 12b, 12c, 14a, 16a** bei T = 298 K und T = 77 K (Anregung jeweils bei 350 nm).

**Figur 19:** Emissionsspektrum und Emissionsquantenausbeute von **2c** als pulverförmige Probe, als reiner Film und in PMMA-Matrix bei 298 K (Anregung jeweils bei 350 nm).

## Patentansprüche

1. Kupfer(I)-Komplex zur Emission von Licht mit einer Struktur gemäß Formel A

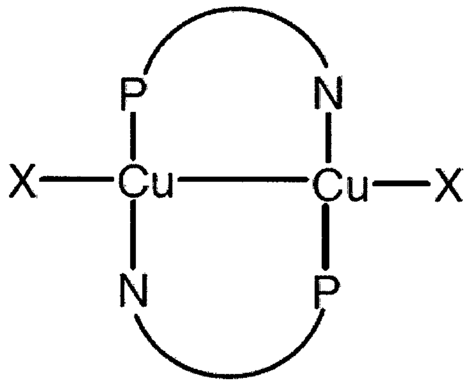

**Formel A**

worin bedeutet:

Cu: Cu(I);
X: Cl, Br, I, SCN, CN, und/oder Alkinyl (R*-≡) (R* ist definiert wie R);
P∩N: ein mit einem N-Heterocyclus substituierter Phosphanligand, mit einer Struktur gemäß Formel B

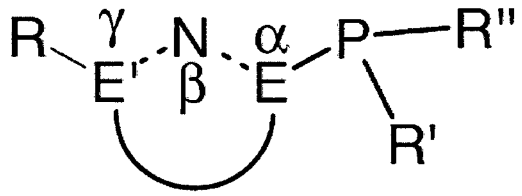

**Formel B**

worin bedeutet:

E: ein Kohlenstoff- oder Stickstoffatom;
E': ein Kohlenstoff- oder Stickstoffatom, das nicht mit einem Wasserstoffatom substituiert ist;

gestrichelte Bindung: eine Einfach- oder Doppelbindung;

R: Alkyl-Rest $[CH_3-(CH_2)_n-]$ (n = 0 - 20), optional verzweigt oder mit Halogenen (F, Cl, Br, I) substituiert, oder Aryl-Rest (insbesondere Phenyl), optional mit Alkyl-Gruppen, Halogenen (F, Cl, Br, I), Silan- $(-SiR^*_3)$ (R* definiert wie R1 unten) oder Ethergruppen -OR** (R** definiert wie R1 unten) substituiert, oder ungesättigte Gruppe wie Alkenyl und Alkinyl-Gruppen, optional wiederum mit Alkyl-Gruppen, Halogenen (F, Cl, Br, I), Silan- $(-SiR^{***}_3)$ oder Ethergruppen -R*** (R*** definiert wie R1 unten) substituiert, wobei R kein Wasserstoffatom ist;
R', R": Alkyl-Gruppen $[CH_3-(CH_2)_n-]$ (n = 0 - 20, bevorzugt n > 6), die auch verzweigt oder cyclisch sein können, oder
Aryl- und Heteroarylgruppen, die optional mit Alkyl-Gruppen, Halogenen (F, Cl, Br, I), Silan- $(-SiR^*_3)$ oder Ethergruppen -OR* (R* definiert wie R1) substituiert sind,
wobei R' und R" jeweils direkt an dem Phosphoratom des Phosphan-Liganden gebunden sind;

und wobei der N-Heterocyclus ein aromatischer 6- oder 5-Ring ist, der ausgewählt ist aus:

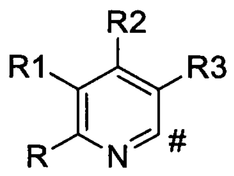 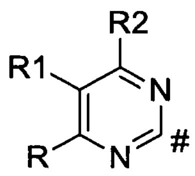 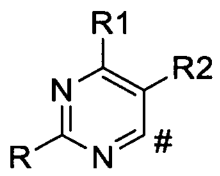 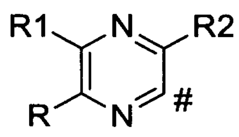 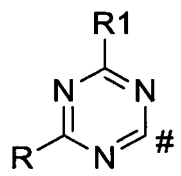

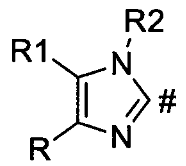 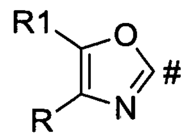 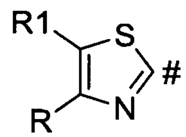 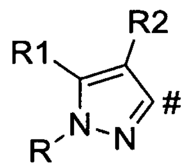

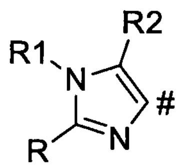 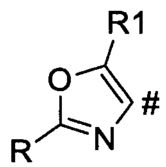 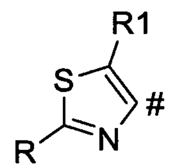

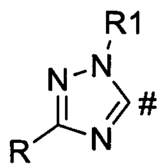 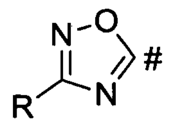 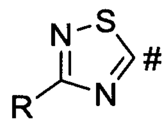 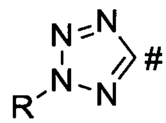

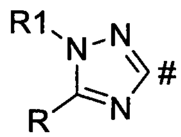 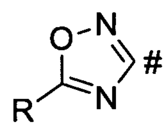 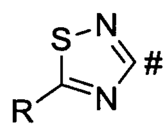 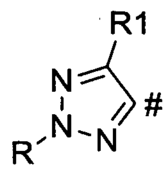

wobei

R1, R2, R3: definiert wie R, wobei R1, R2, R3 optional ein Wasserstoffatom ist;
und wobei
R, R1, R2, R3 optional annelierte Ringsysteme bilden; und wobei
der N-Heterocyclus an der mit "#" gekennzeichneten Positionen mit dem Phosphoratom verknüpft ist.

2. Kupfer(I)-Komplex nach Anspruch 1, wobei R, R1, R2, R3, R' und/oder R" die Löslichkeit des Kupfer(I)-Komplexes in organischen Lösungsmitteln erhöht.

3. Kupfer(I)-Komplex nach Anspruch 1 oder 2, der

- einen ΔE-Abstand zwischen dem untersten Triplett-Zustand und dem darüber liegenden Singulett-Zustand von kleiner als 2500 $cm^{-1}$ aufweist;
- eine Emissionsquantenausbeute von größer 20 %; oder
- eine Emissionslebensdauer von höchstens 20 μs aufweist.

4. Verwendung eines Kupfer(I)-Komplexes nach Anspruch 1 bis 3 zur Emission von Licht, insbesondere in einer Emitterschicht in einer opto-elektronischen Vorrichtung.

5. Verfahren zur Herstellung einer opto-elektronischen Vorrichtung,
wobei ein Kupfer(I)-Komplex nach Anspruch 1 bis 3 verwendet wird,
insbesondere wobei der Kupfer(I)-Komplex nass-chemisch, mittels kolloidaler Suspension oder mittels Sublimation auf einen festen Träger aufgebracht wird.

6. Verfahren nach Anspruch 5,
wobei die Herstellung nass-chemisch erfolgt und das Verfahren die folgenden Schritte aufweist:

- Aufbringung eines in einem ersten Lösungsmittel gelösten ersten Kupfer(I)-Komplexes auf einen Träger, und
- Aufbringung eines in einem zweiten Lösungsmittel gelösten zweiten Kupfer(I)-Komplexes auf den Träger;

wobei

- der erste Kupfer(I)-Komplex nicht in dem zweiten Lösungsmittel löslich ist und
- der zweite Kupfer(I)-Komplex nicht in dem ersten Lösungsmittel löslich ist;

und wobei der erste Kupfer(I)-Komplex und/oder der zweite Kupfer(I)-Komplex ein Kupfer(I)-Komplex nach Anspruch 1 bis 3 ist.

7. Verfahren nach Anspruch 6, aufweisend den folgenden Schritt:

- Aufbringung eines in dem ersten Lösungsmittel oder in einem dritten Lösungsmittel gelösten dritten Kupfer(I)-Komplex auf den Träger,

wobei der dritte Kupfer(I)-Komplex ein Kupfer(I)-Komplex nach Anspruch 1 bis 3 ist.

8. Verfahren nach Anspruch 7, wobei die opto-elektronische Vorrichtung eine Weißlicht-OLED ist, wobei

- der erste Kupfer(I)-Komplex ein Rotlichtemitter ist,
- der zweite Kupfer(I)-Komplex ein Grünlichtemitter ist und
- der dritte Kupfer(I)-Komplex ein Blaulichtemitter ist.

9. Opto-elektronische Vorrichtung, aufweisend einen Kupfer(I)-Komplex nach den Ansprüchen 1 bis 3, der einen ΔE-Abstand zwischen dem untersten Triplett-Zustand und dem darüber liegenden Singulett-Zustand zwischen 50 $cm^{-1}$ und 2500 $cm^{-1}$ aufweist.

10. Opto-elektronische Vorrichtung nach Anspruch 9,
wobei der Anteil des Kupfer(I)-Komplexes in einer Emitterschicht 2 bis 100 Gew.-%, bezogen auf das Gesamtgewicht der Emitterschicht, beträgt.

11. Opto-elektronische Vorrichtung nach Anspruch 9 bis 10 in Form einer organischen Leuchtdiode (OLED), **gekennzeichnet durch** eine einen Kupfer(I)-Komplex nach Anspruch 1 bis 3 aufweisende Emitterschicht, wobei der Anteil des Kupfer(I)-Komplexes in der Emitterschicht zwischen 2 bis 100 Gew.-%, bezogen auf das Gesamtgewicht der Emitterschicht, beträgt.

12. Verwendung nach Anspruch 4, Verfahren nach Anspruch 5 bis 7, opto-elektronische Vorrichtung nach Anspruch 9 bis 11, wobei die opto-elektronische Vorrichtung ausgewählt ist aus der Gruppe bestehend aus organischen Leuchtidioden (OLEDs), lichtemittierenden elektrochemischen Zellen (LEECs oder LECs), OLED-Sensoren, insbesondere

nicht hermetisch nach außen abgeschirmten Gas- und Dampf-Sensoren, optischen Temperatur-Sensoren, organischen Solarzellen (OSCs), organischen Feldeffekttransistoren, organischen Lasern, organischen Dioden, organischen Photodioden und "down conversion" Systemen.

## Claims

**1.** Copper(I) complex for the emission of light with a structure according to formula A

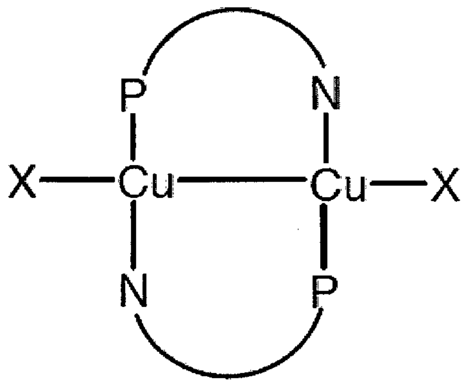

**Formula A**

wherein:

Cu: Cu(I);
X: Cl, Br, I, SCN, CN, and/or alkynyl (R*-≡) (R* is defined like R);
P∩N: a phosphine ligand substituted with an N-hetereocycle with a structure according to formula B

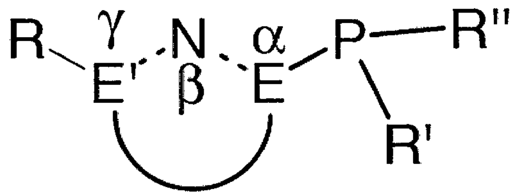

**Formula B**

wherein:

E: a carbon or nitrogen atom;
E': a carbon or nitrogen atom, which is not substituted with a hydrogen atom;

dotted bond: a single or double bond;

R: alkyl group [$CH_3$-$(CH_2)_n$-] (n = 0 - 20), optionally branched or substituted with halogens (F, Cl, Br, I), or aryl group (especially phenyl), optionally substituted with alkyl groups, halogens (F, Cl, Br, I), silane (-Si$R^*_3$) (R* defined like R1 below) or ether groups -OR** (R** defined like R1 below), or unsaturated group such as alkenyl and alkynyl groups, optionally substituted again with alkyl groups, halogens (F, Cl, Br, I), silane (-Si$R^{***}_3$) or ether groups -OR*** (R*** defined like R1 below),
wherein R is no hydrogen atom;
R', R": alkyl groups [$CH_3$-$(CH_2)_n$-] (n = 0 - 20, preferably n > 6), which can also be branched or cyclic, or aryl and heteroaryl groups, which is optionally substituted with alkyl groups, halogens (F, Cl, Br, I), silane (-Si$R^*_3$) or ether groups -OR* (R* defined like R1),
wherein R' und R" each are directly bound to the phosphorous atom of the phosphine ligand;

and wherein the N-heterocycle is an aromatic 6- or 5-membered ring, which is chosen from:

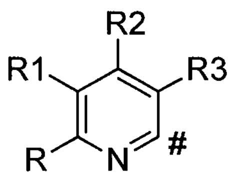
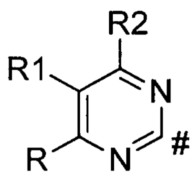
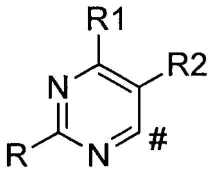
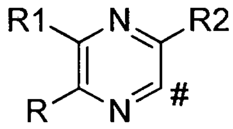
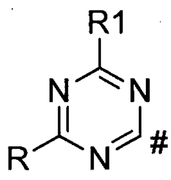
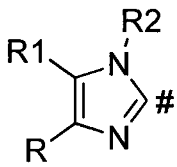
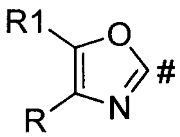
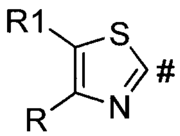
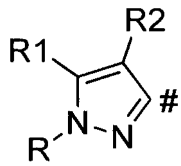
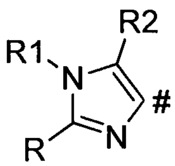
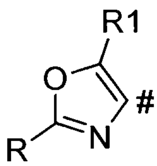
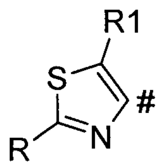
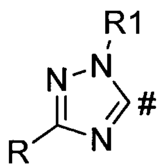
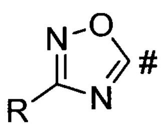
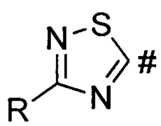
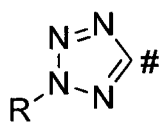
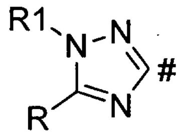
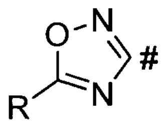
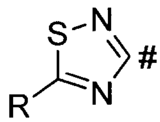
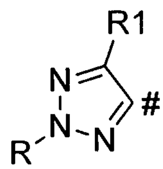

wherein

R1, R2, R3: defined like R, wherein R1, R2, R3 optionally is a hydrogen atom;
and wherein
R, R1, R2, R3 optionally form annulated ring systems;
and wherein
the N-heterocycle is linked to the phosphorous atom at the positions marked with "#".

**2.** Copper(I) complex according to claim 1, wherein R, R1, R2, R3, R’ and/or R" increase the solubility of the copper(I) complex in organic solvents.

**3.** Copper(I) complex according to claim 1 or 2, which comprises

- a $\Delta E(S_1\text{-}T_1)$-value between the lowest triplet state and the singlet state above it of smaller than 2500 $cm^{-1}$;
- an emission quantum yield of larger than 20 %;
- an emission life time of at the most 20 $\mu s$.

**4.** Use of a copper(I) complex according to claims 1 to 3 for the emission of light, in particular in an emitter layer in an optoelectronic device.

**5.** A method for a manufacturing an optoelectronic device,

wherein a copper(I) complex according to claims 1 to 3 is used, in particular wherein the copper(I) complex is applied to a solid carrier wet-chemically, by means of colloidal suspension or by means of sublimation.

**6.** Method according to claim 5, wherein the manufacturing is performed wet-chemically and the method comprises the following steps:

- Depositing a first copper(I) complex that is dissolved in a first solvent onto a carrier, and
- Depositing a second copper(I) complex onto the carrier that is dissolved in a second solvent, wherein;
- the first copper(I) complex is not soluble in the second solvent and
- the second copper(I) complex is not soluble in the first solvent;

and wherein the first copper(I) complex and/or the second copper(I) complex is a copper(I) complex according to claims 1 to 3.

**7.** Method according to claim 6, comprising the following step:

- Depositing a third copper(I) complex onto the carrier that is dissolved in the first solvent or in a third solvent,

wherein the third copper(I) complex is a copper(I)complex according to claims 1 to 3.

**8.** Method according to claim 7, wherein the optoelectronic device is a white light-OLED, wherein

- the first copper(I) complex is a red light emitter,
- the second copper(I) complex is a green light emitter and
- the third copper(I) complex is a blue light emitter.

**9.** Optoelectronic device, comprising a copper(I) complex which has a ΔE difference between the lowest triplet state and the singlet state above it of between 50 $cm^{-1}$ and 2500 $cm^{-1}$.

**10.** Optoelectronic device according to claim 9, wherein the fraction of the copper(I) complex in the emitter layer is 2 to 100 weight-% with respect to the total weight of the emitter layer.

**11.** Optoelectronic device according to claims 9 or 10 in the form of an organic light emitting diode (OLED), **characterized by** an emitter layer that comprises a copper(I) complex according to claims 1 to 3, wherein the fraction of the copper(I) complex in the emitter layer is between 2 to 100 weight-% with respect to the total weight of the emitter layer.

**12.** Use according to claim 4, method according to claims 5 to 7, optoelectronic device according to claims 9 to 11, wherein the optoelectronic device is chosen from the group consisting of organic light emitting diodes (OLEDs), light-emitting electrochemical cells (LEECs or LECs), OLED-sensors, especially gas and vapor sensors that are not hermetically sealed from the outside, optical temperature sensors, organic solar cells (OSCs), organic field-effect transistors, organic lasers, organic diodes, organic photo diodes and "down conversion" systems.

## Revendications

**1.** Complexe du cuivre (I) pour l'émission de lumière présentant une structure selon la formule A

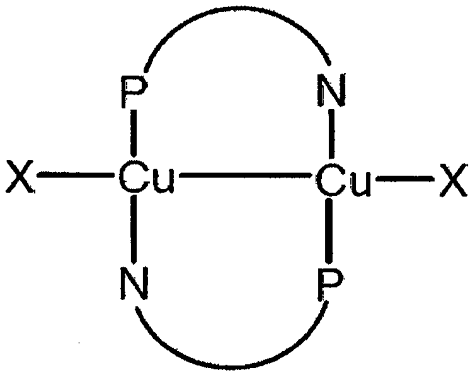

Formule A

dans laquelle :

Cu : signifie Cu(I) ;
X : signifie Cl, Br, I, SCN, CN et/ou alcynyle (R*-≡) (R* étant défini comme R) ;
P∩N: signifie un ligand phosphane substitué par un N-hétérocycle, présentant une structure selon la formule B

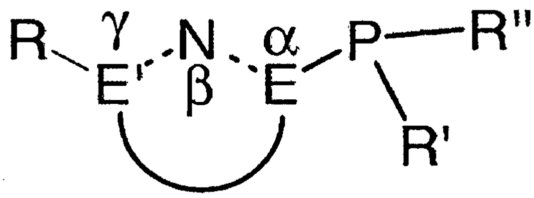

Formule B

dans laquelle :

E : signifie un atome de carbone ou un atome d'azote ;
E' : signifie un atome de carbone ou un atome d'azote, qui n'est pas substitué par un atome d'hydrogène ;

liaison en pointillés : une simple ou une double liaison ;

R : signifie un radical alkyle $[CH_3-(CH_2)_n-]$ (n = 0-20), éventuellement ramifié ou substitué par des halogènes (F, Cl, Br, I), ou un radical aryle (en particulier phényle), éventuellement substitué par des groupes alkyle, des halogènes (F, Cl, Br, I), des groupes silane ($-SiR^*_3$) (R* étant défini comme R1 ci-dessous) ou des groupes éther - OR** (R** étant défini comme R1 ci-dessous, ou des groupes insaturés tels que des groupes alcényle et alcynyle, à leur tour de nouveau substitués par des groupes alkyle, des halogènes (F, Cl, Br, I), des groupes silane ($-SiR^{***}_3$) ou des groupes éther -OR*** (R*** étant défini comme R1 ci-dessous), R n'étant pas un atome d'hydrogène ;
R', R" : signifient des groupes alkyle $[CH_3-(CH_2)-]$ (n = 0-20, de préférence n > 6), qui peuvent également être ramifiés ou cycliques, ou des groupes aryle et hétéroaryle, qui sont éventuellement substitués par des groupes alkyle, des halogènes (F, Cl, Br, I), des groupes silane ($-SiR^*_3$) ou des groupes éther-OR* (R* étant défini comme R1), R' et R" étant à chaque fois liés directement à l'atome de phosphore du ligand phosphane ;

et le N-hétérocycle étant un cycle aromatique à 5 ou 6 chaînons, qui est choisi parmi :

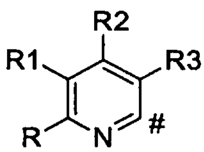 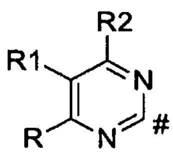 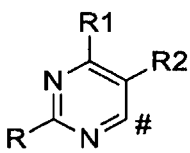 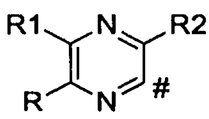 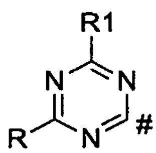

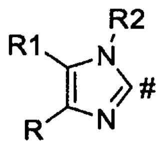 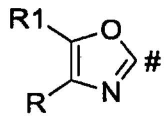 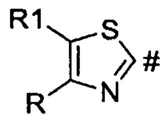 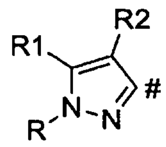

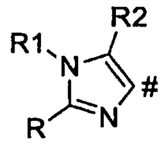 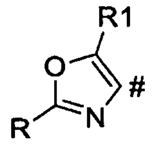 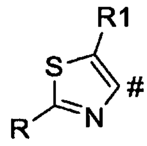

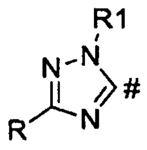 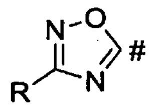 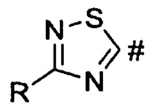 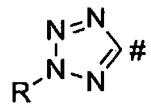

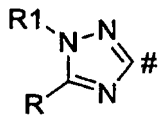 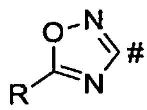 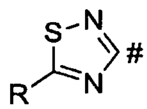 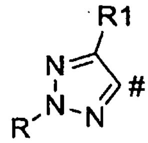

où

R1, R2, R3 : sont définis comme R ; R1, R2, R3 représentant éventuellement un atome d'hydrogène ; et
R, R1, R2, R3 formant éventuellement des systèmes cycliques condensés ; et
le N-hétérocycle étant lié aux positions **caractérisées par** "#" à l'atome de phosphore.

2. Complexe du cuivre (I) selon la revendication 1, R, R1, R2, R3, R' et/ou R" augmentant la solubilité du complexe du cuivre (I) dans les solvants organiques.

3. Complexe du cuivre (I) selon la revendication 1 ou 2, qui

   - présente un écart $\Delta E$, entre l'état triplet inférieur et l'état singulet supérieur à celui-ci, inférieur à 2500 $cm^{-1}$ ;
   - présente un rendement de quanta d'émission supérieur à 20% ; ou
   - présente une durée de vie d'émission d'au plus 20 $\mu s$.

4. Utilisation d'un complexe du cuivre (I) selon la revendication 1 à 3 pour l'émission de lumière, en particulier dans une couche émettrice dans un dispositif optoélectronique.

5. Procédé pour la fabrication d'un dispositif optoélectronique, un complexe du cuivre (I) selon la revendication 1 à 3 étant utilisé, en particulier, un complexe du cuivre (I) étant appliqué par voie chimique humide, au moyen d'une suspension colloïdale ou au moyen d'une sublimation sur un support solide.

6. Procédé selon la revendication 5, la fabrication étant réalisée par voie chimique humide et le procédé présentant des étapes suivantes :

   - application d'un premier complexe du cuivre (I) dissous dans un premier solvant sur un support, et
   - application d'un deuxième complexe du cuivre (I) dissous dans un deuxième solvant sur le support,
   - le premier complexe du cuivre (I) n'étant pas soluble dans le deuxième solvant et
   - le deuxième complexe du cuivre (I) n'étant pas soluble dans le premier solvant ;

   et le premier complexe du cuivre (I) et/ou le deuxième complexe du cuivre (I) étant un complexe du cuivre (I) selon la revendication 1 à 3.

7. Procédé selon la revendication 6, comprenant l'étape suivante :

- application d’un troisième complexe du cuivre (I) dissous dans le premier solvant ou dans un troisième solvant sur le support,

le troisième complexe du cuivre (I) étant un complexe du cuivre (I) selon la revendication 1 à 3.

**8.** Procédé selon la revendication 7, le dispositif optoélectronique étant une DELO à lumière blanche,

- le premier complexe du cuivre (I) étant un émetteur de lumière rouge,
- le deuxième complexe du cuivre (I) étant un émetteur de lumière verte et
- le troisième complexe du cuivre (I) étant un émetteur de lumière bleue.

**9.** Dispositif optoélectronique, présentant un complexe du cuivre (I) selon les revendications 1 à 3, qui présente un écart $\Delta E$, entre l’état triplet inférieur et l’état singulet supérieur à celui-ci, entre 50 $cm^{-1}$ et 2500 $cm^{-1}$.

**10.** Dispositif optoélectronique selon la revendication 9, la proportion du complexe du cuivre (I) dans une couche émettrice étant de 2 à 100% en poids par rapport au poids total de la couche émettrice.

**11.** Dispositif optoélectronique selon la revendication 9 à 10 sous forme d’une diode électroluminescente organique (DELO), **caractérisé par** une couche émettrice présentant un complexe du cuivre (I) selon la revendication 1 à 3, la proportion du complexe du cuivre (I) dans la couche émettrice étant de 2 à 100% en poids par rapport au poids total de la couche émettrice.

**12.** Utilisation selon la revendication 4, procédé selon la revendication 5 à 7, dispositif optoélectronique selon la revendication 9 ou 11, le dispositif optoélectronique étant choisi dans le groupe constitué par les diodes électroluminescentes organiques (DELO), les cellules électrochimiques émettrices de lumière (CEEL ou CEL), les capteurs DELO, en particulier des capteurs de gaz et de vapeur non hermétiquement protégés par rapport à l’extérieur, les capteurs optiques de température, les cellules solaires organiques (CSO), les transistors organiques à effet de champ, les lasers organiques, les diodes organiques, les photodiodes organiques et les systèmes de "down conversion".

Figur 1

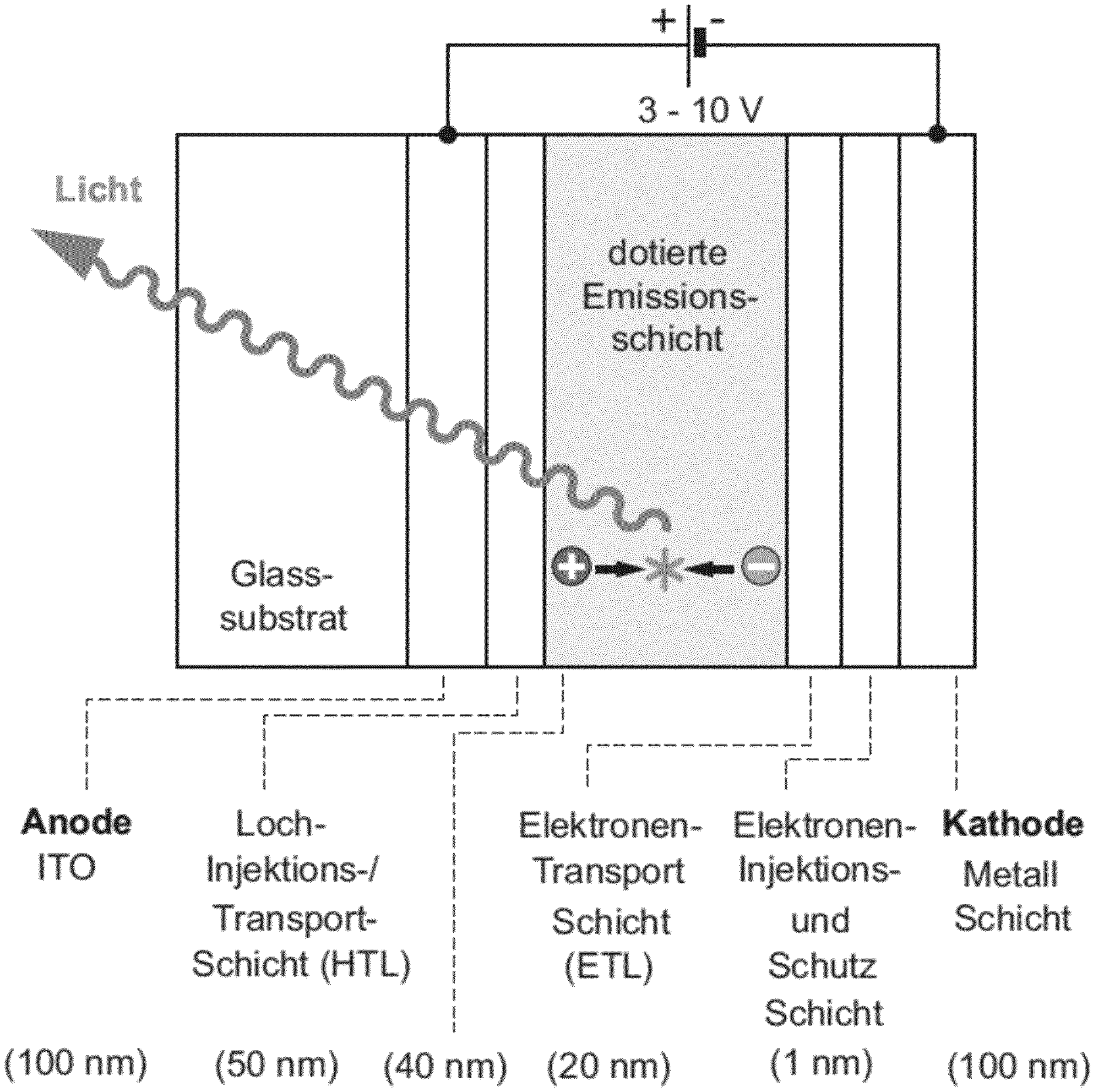
+
-
3 - 10 V
Licht
dotierte Emissions-schicht
Glass-substrat
Anode
ITO
(100 nm)
Loch-Injektions-/Transport-Schicht (HTL)
(50 nm)
(40 nm)
Elektronen-Transport Schicht (ETL)
(20 nm)
Elektronen-Injektions- und Schutz Schicht
(1 nm)
Kathode
Metall Schicht
(100 nm)

Figur 2

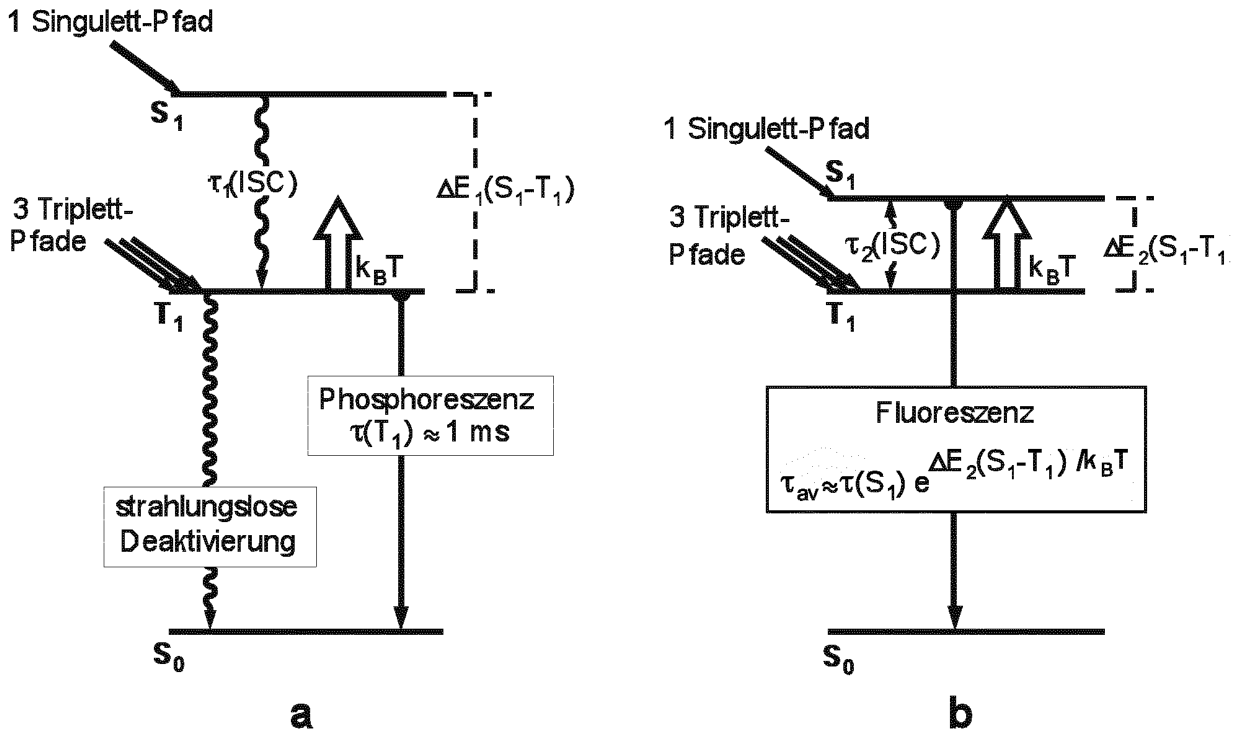
1 Singulett-Pfad
S1
3 Triplett-
Pfade
τ1(ISC)
ΔE1(S1-T1)
kBT
T1
Phosphoreszenz
τ(T1) ≈ 1 ms
strahlungslose
Deaktivierung
S0
a
1 Singulett-Pfad
S1
3 Triplett-
Pfade
τ2(ISC)
kBT
ΔE2(S1-T1)
T1
Fluoreszenz
τav≈τ(S1) e^ΔE2(S1-T1)/kBT
S0
b

**Figur 3**

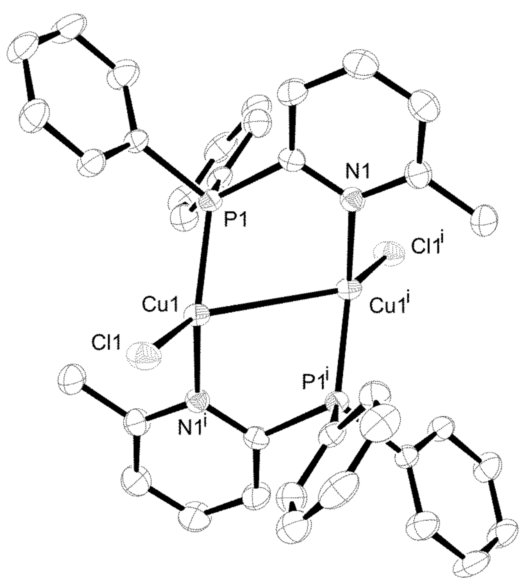

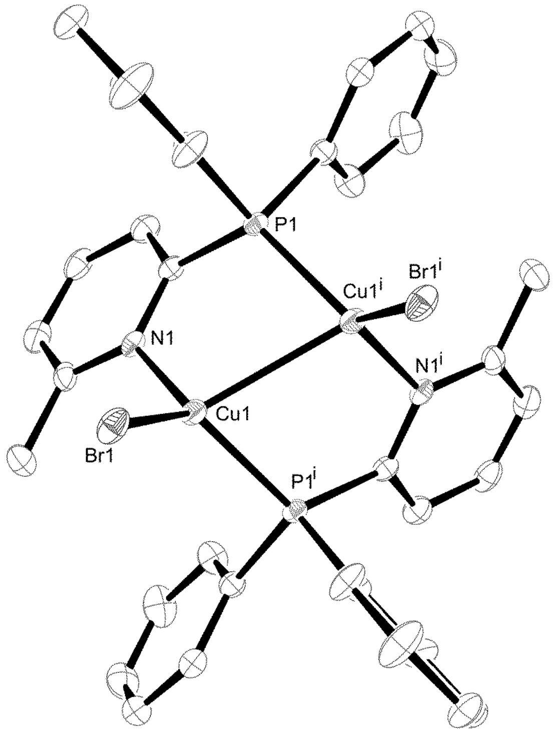

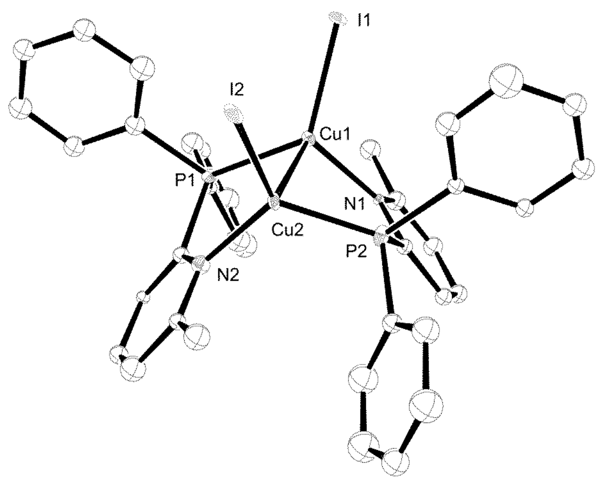

Figur 4

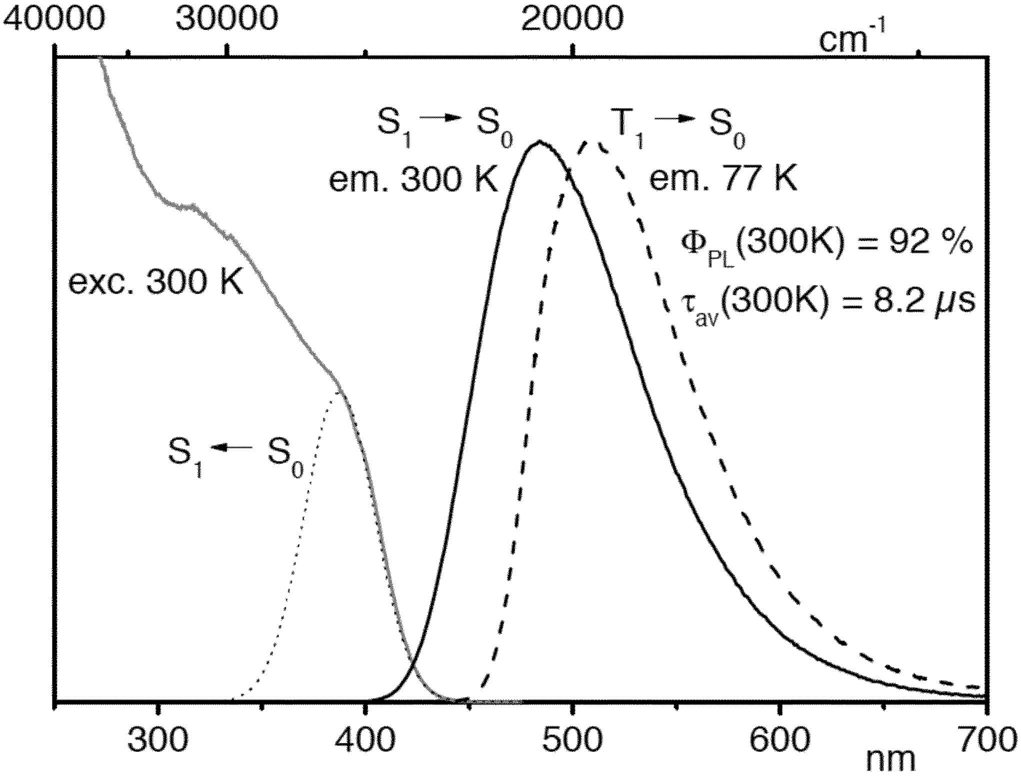


Figur 5

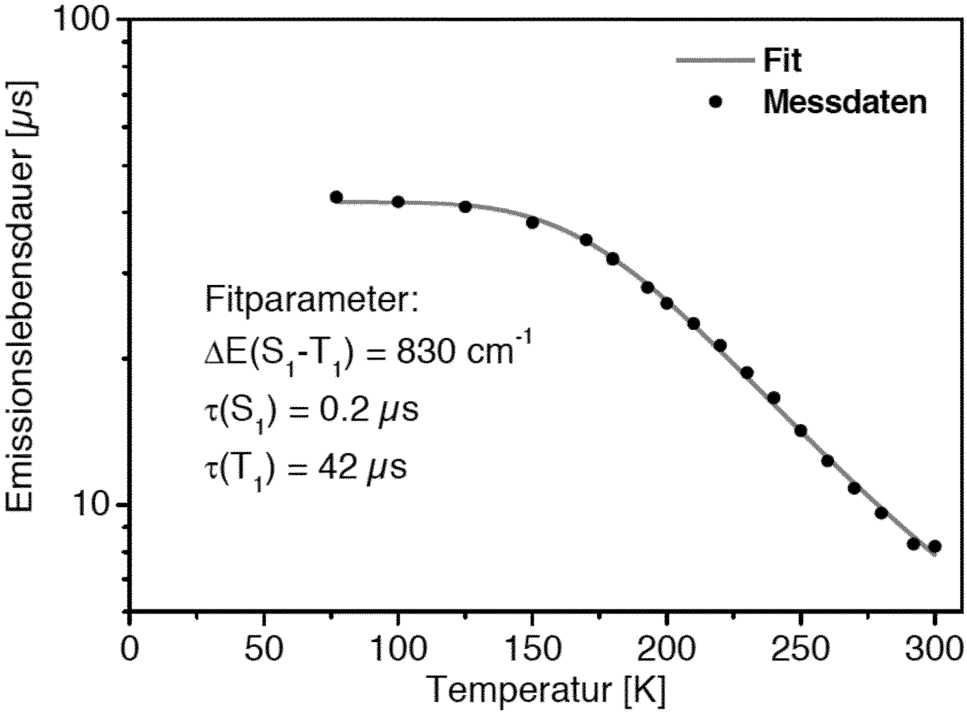

**Figur 6**

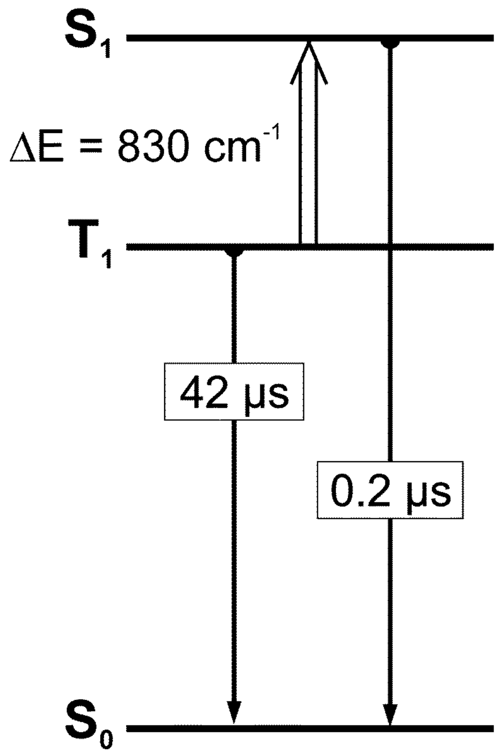


**Figur 7**

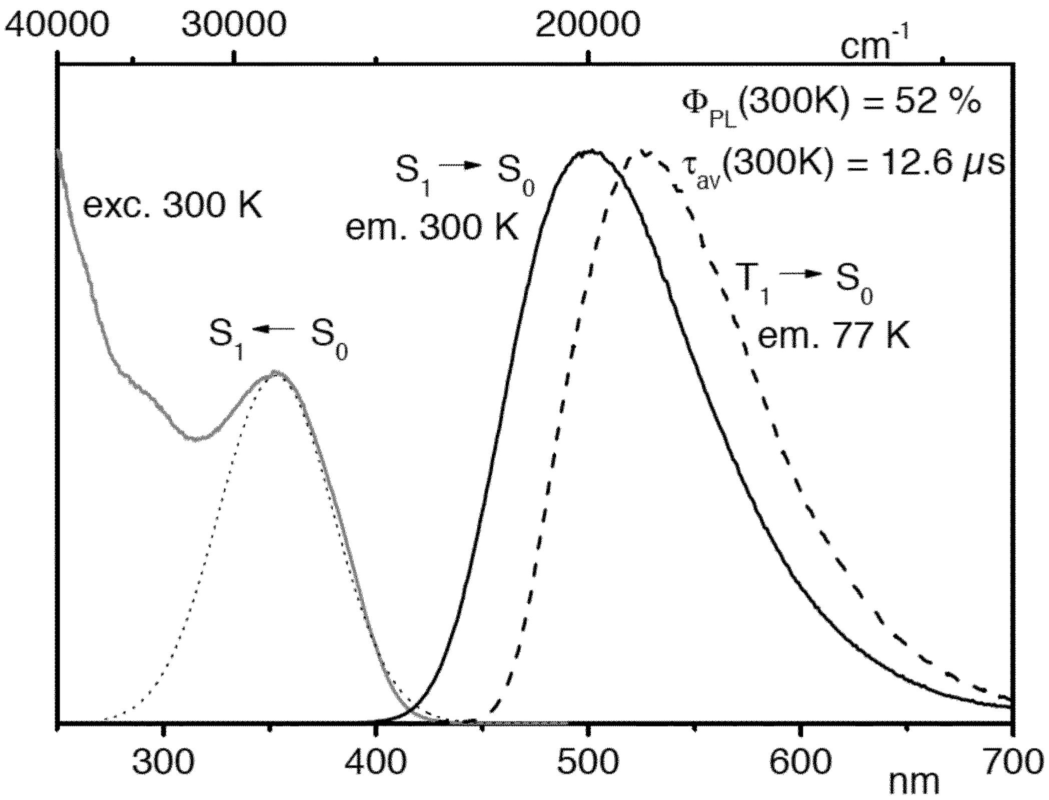

Figur 8

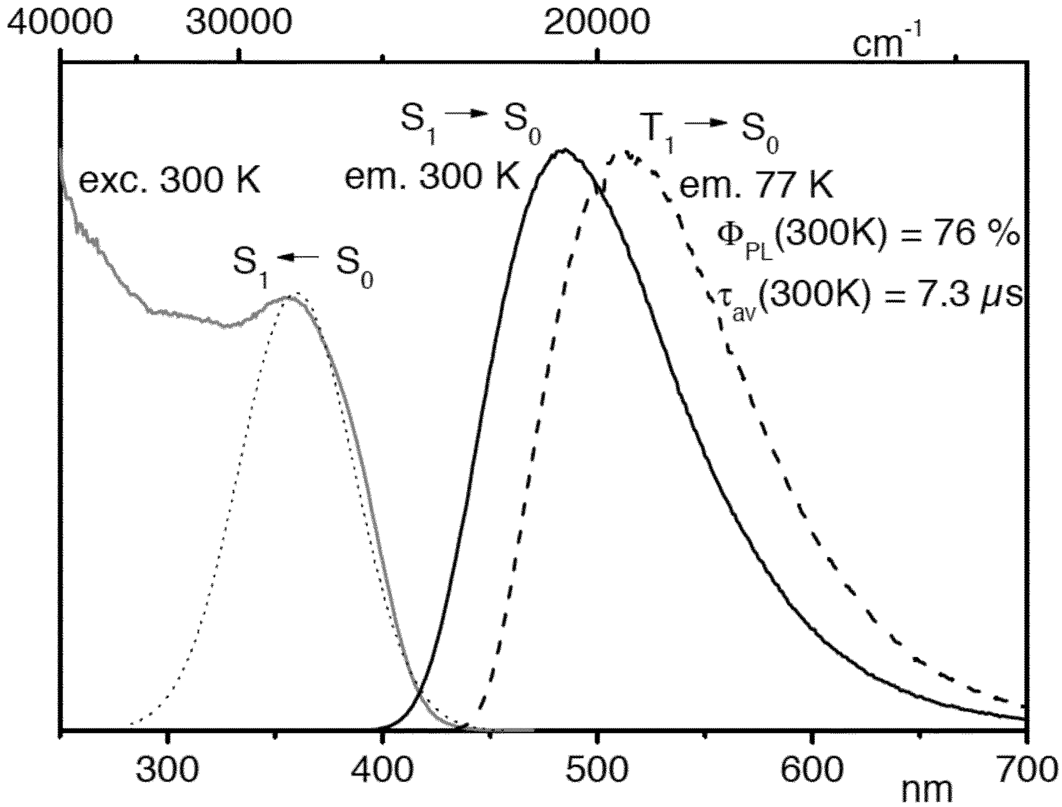


Figur 9

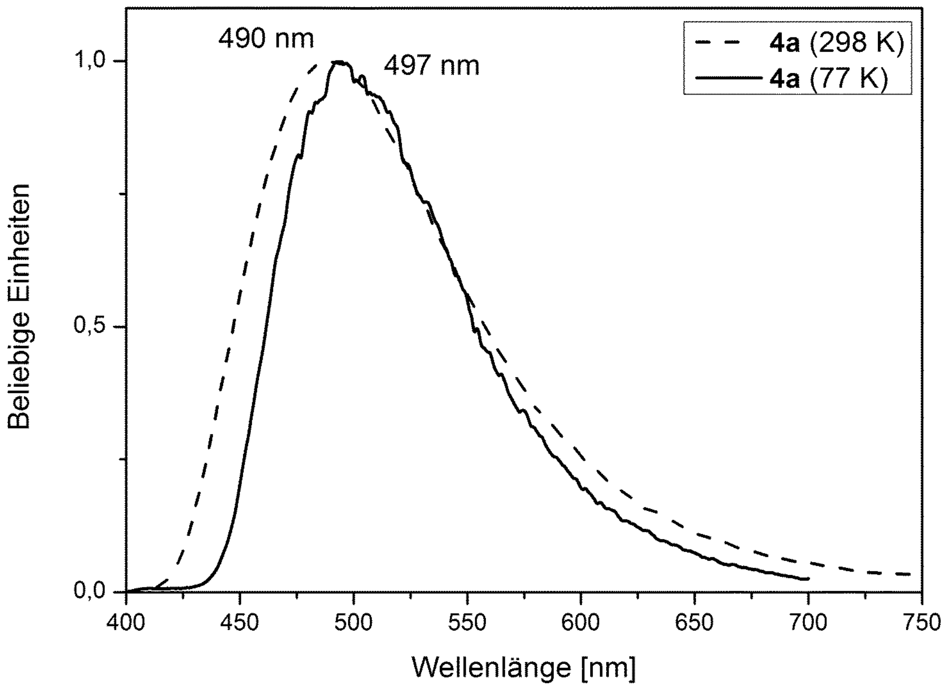

Figur 10

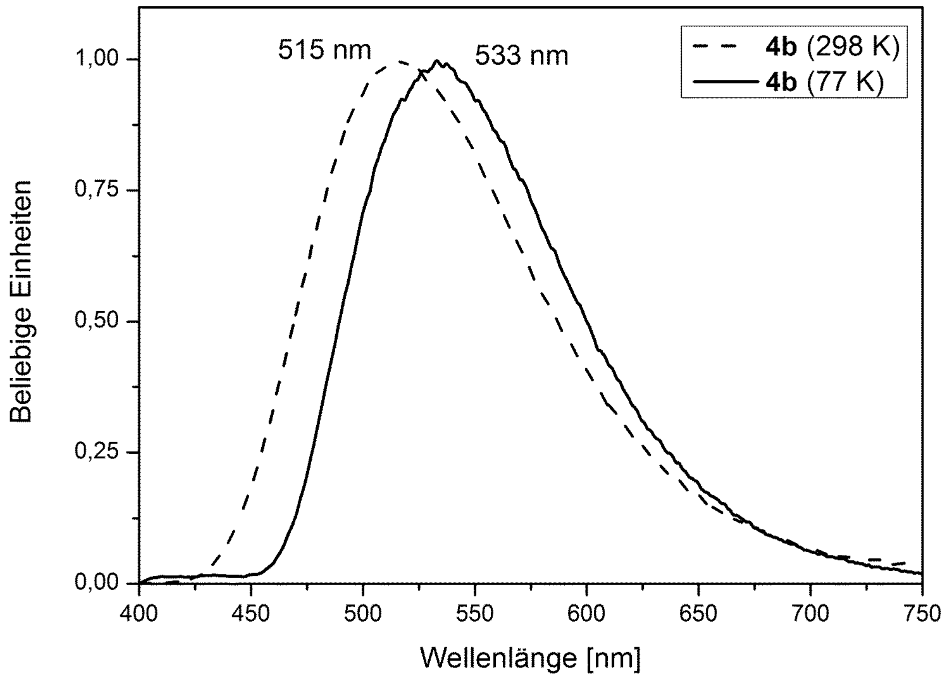


Figur 11

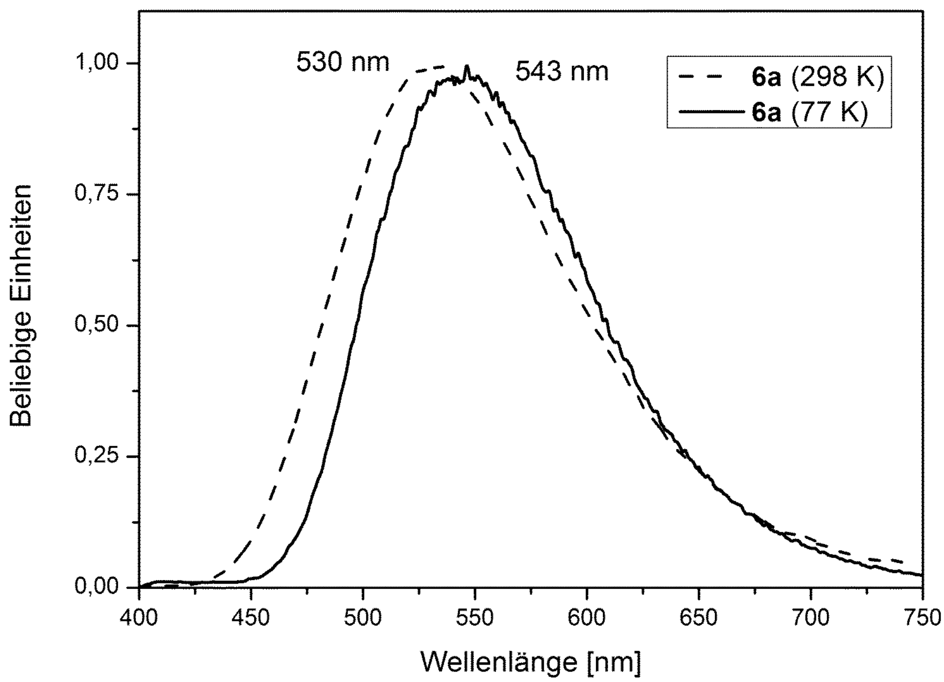

Figur 12

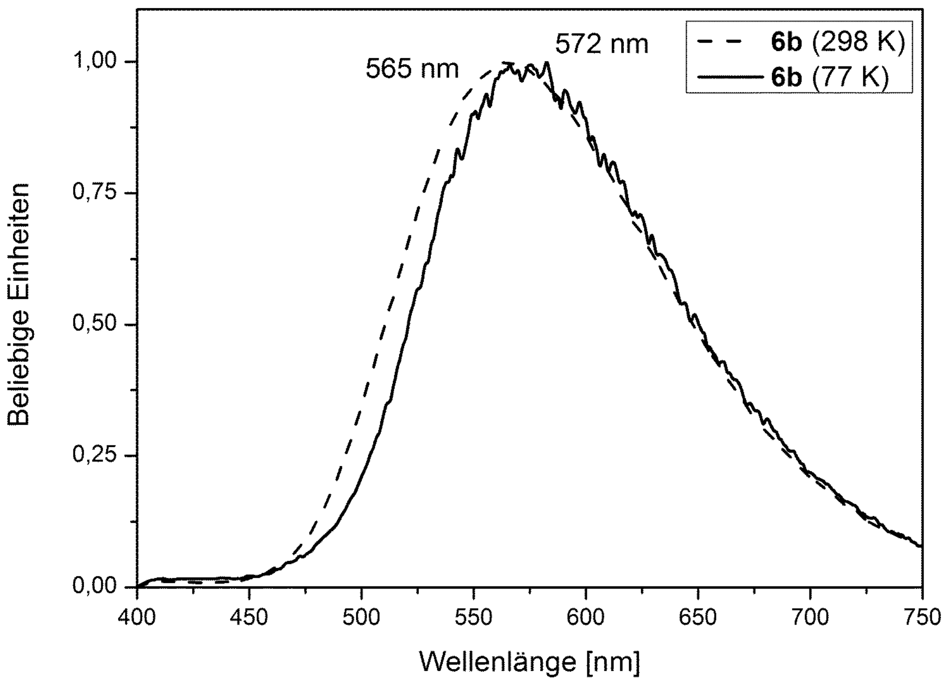


Figur 13

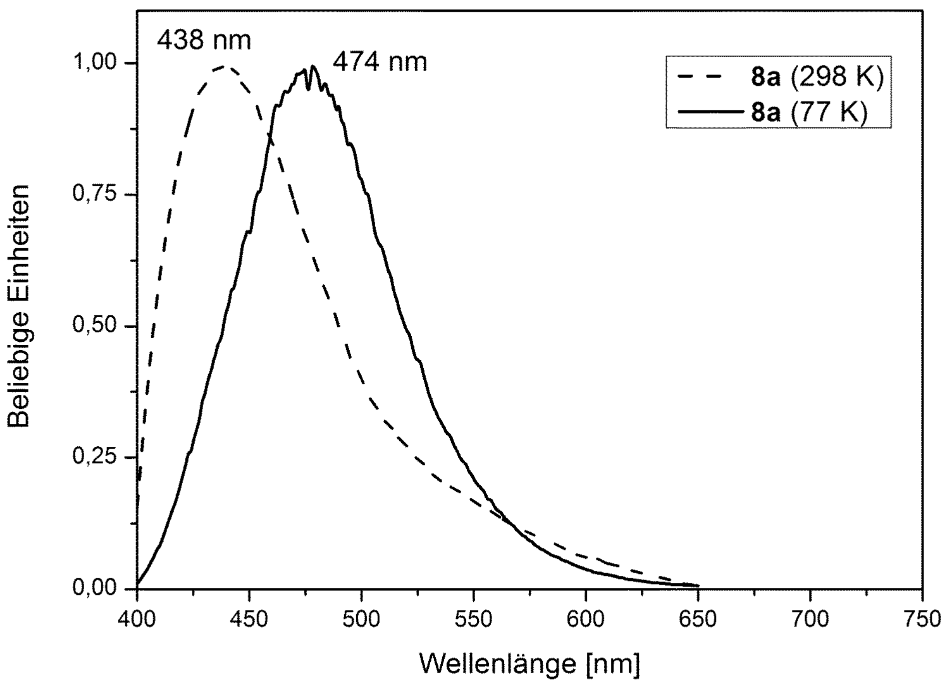

**Figur 14**

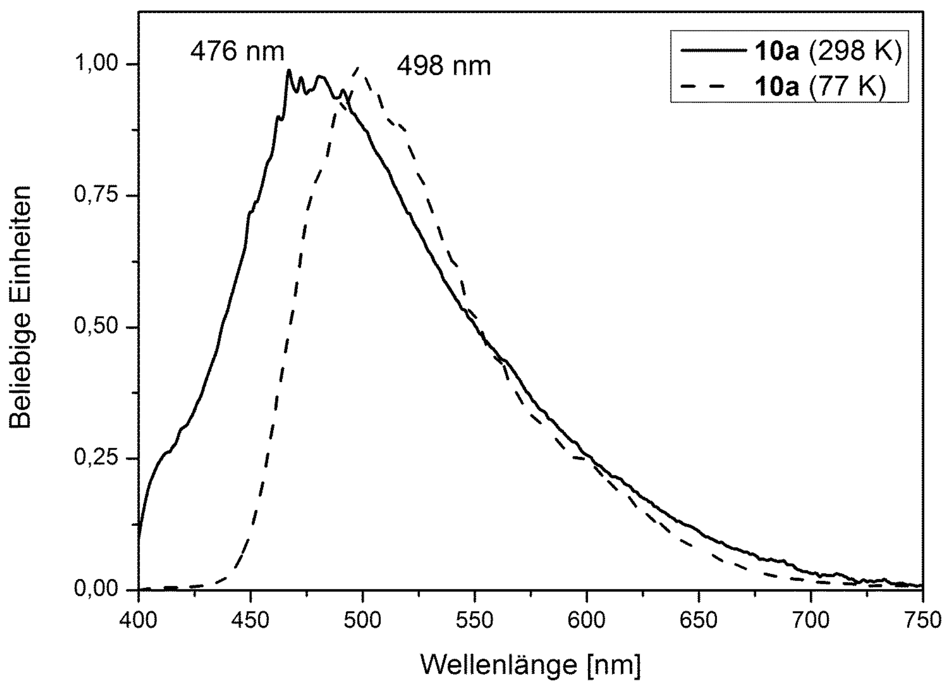


**Figur 15**

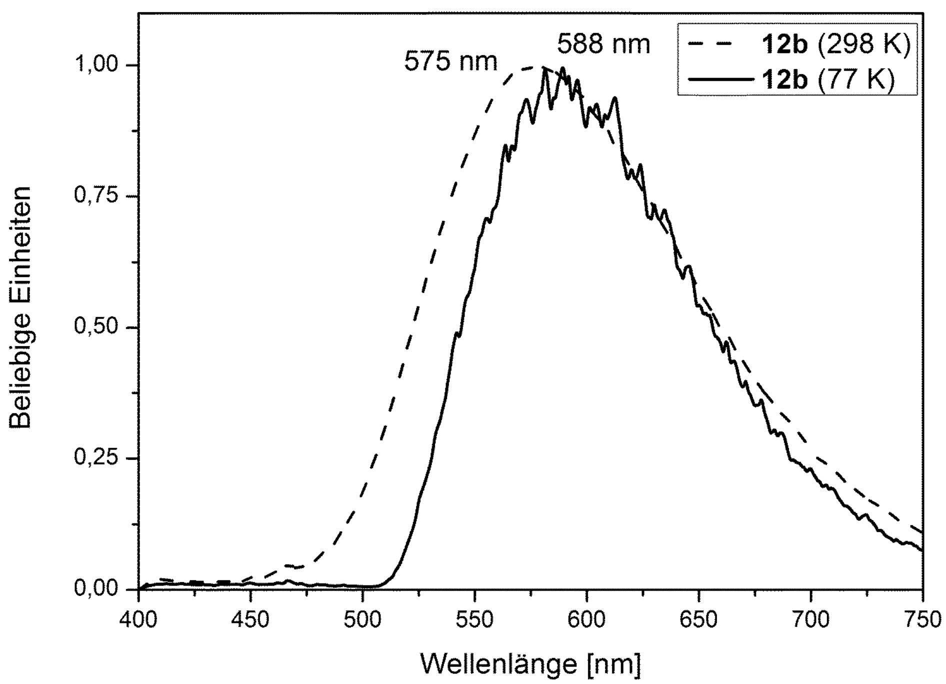

**Figur 16**

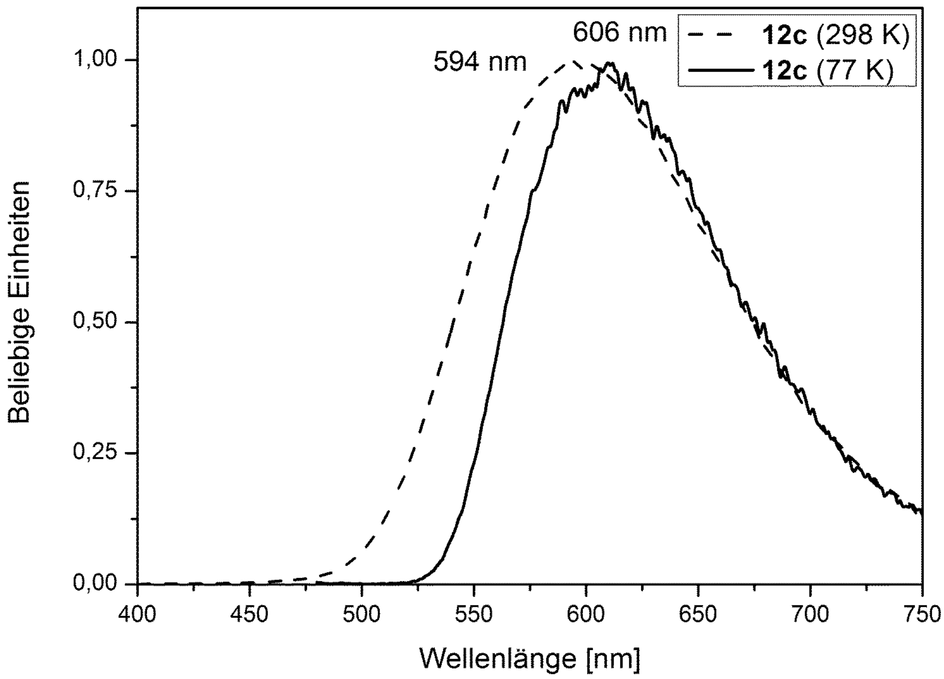


**Figur 17**

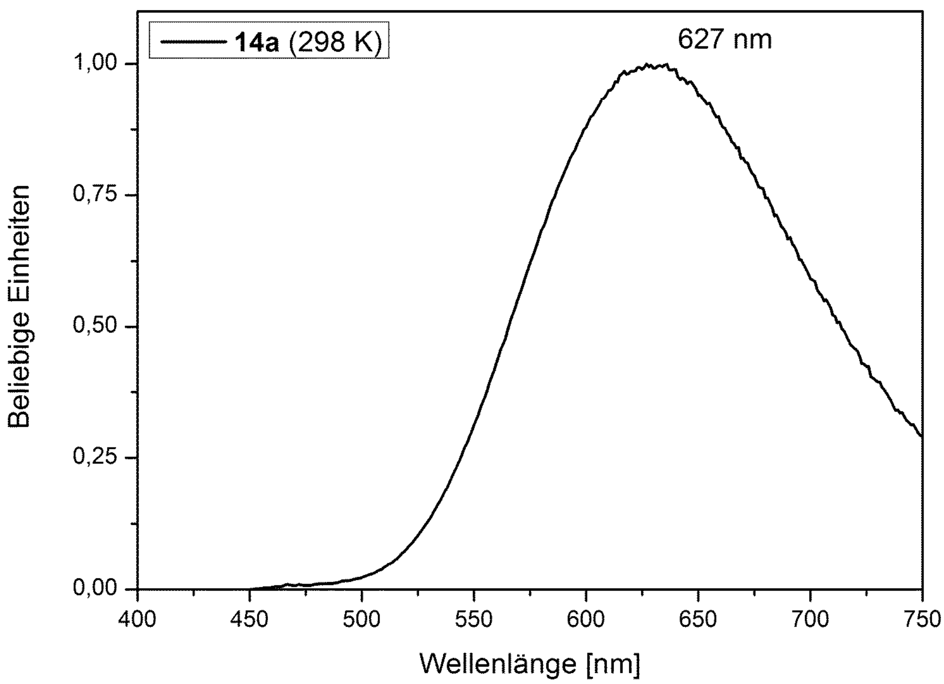

**Figur 18**

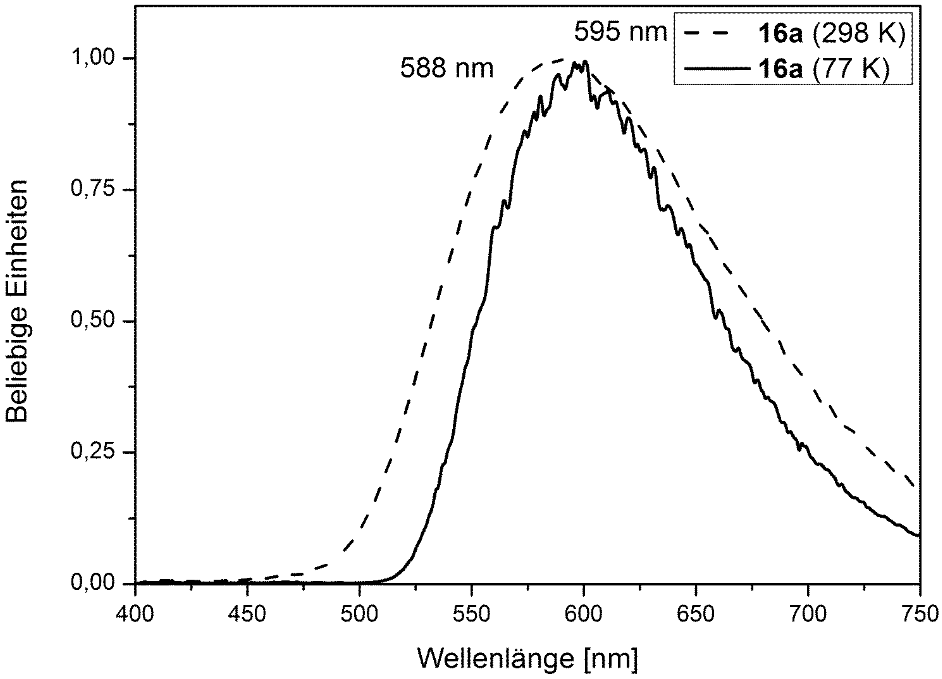


**Figur 19**

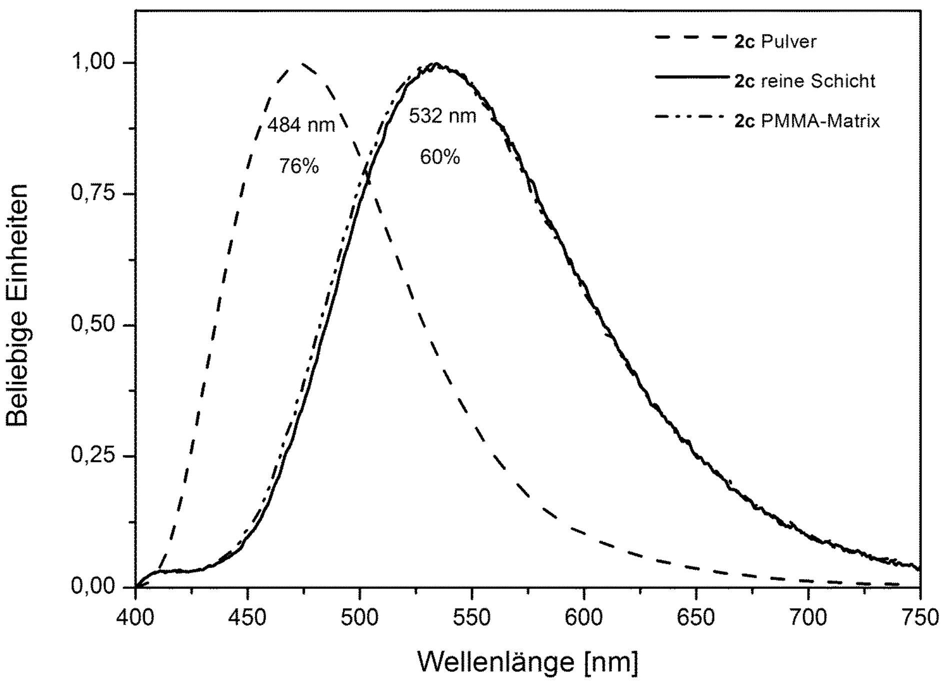

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- WO 2005054404 A1


### In der Beschreibung aufgeführte Nicht-Patentliteratur


- **H. YERSIN.** *Top. Curr. Chem.,* 2004, vol. 241, 1
- **H. YERSIN.** Highly Efficient OLEDs with Phosphorescent Materials. Wiley-VCH, 2008
- **B. TANG et al.** *Appl. Phys. Lett.,* 1987, vol. 51, 913
- **M. A. BALDO ; D. F. O'BRIEN ; M. E. THOMPSON ; S. R. FORREST.** *Phys. Rev. B,* 1999, vol. 60, 14422
- **S. L. MUROV ; J. CARMICHEAL ; G. L. HUG.** Handbook of Photochemistry. Marcel Dekker, 1993, 338
- **B. H. YERSIN.** Highly Efficient OLEDs with Phosphorescent Materials. Wiley-VCH, 2008
- **S. R. FORREST et al.** *Phys. Rev. B,* 2008, vol. 77, 235215
- **J. KIDO et al.** *Jap. J. Appl. Phys.,* 2007, vol. 46, L10